(19) Europäisches Patentamt
European Patent Office
Office européen des brevets

(11) Veröffentlichungsnummer: **0 291 879**
**B1**

# (12) EUROPÄISCHE PATENTSCHRIFT

(45) Veröffentlichungstag der Patentschrift: **07.11.90**

(51) Int. Cl.[5]: **G03F 7/004**, G03F 7/26, B41N 1/14, C07D 239/91

(21) Anmeldenummer: **88107719.2**

(22) Anmeldetag: **13.05.88**

## (54) Photopolymerisierbare Aufzeichnungsmaterialien sowie Photoresistschichten und Flachdruckplatten auf Basis dieser Aufzeichnungsmaterialien sowie neue Chinazolon-4-Verbindungen.

(30) Priorität: **21.05.87 DE 3717034**

(43) Veröffentlichungstag der Anmeldung: **23.11.88 Patentblatt 88/47**

(45) Bekanntmachung des Hinweises auf die Patenterteilung: **07.11.90 Patentblatt 90/45**

(84) Benannte Vertragsstaaten: **BE CH DE FR GB IT LI NL SE**

(56) Entgegenhaltungen:
**DE-A- 2 046 018**
**DE-A- 3 102 760**
**DE-A- 3 410 387**
**US-A- 3 552 973**

(73) Patentinhaber: **BASF Aktiengesellschaft, Carl-Bosch-Strasse 38, D-6700 Ludwigshafen(DE)**

(72) Erfinder: **Aldag, Reinhard, Dr., Gunterstrasse 22, D-6700 Ludwigshafen(DE)**
Erfinder: **Neumann, Peter, Dr., Franz-Schubert-Strasse 1, D-6908 Wiesloch(DE)**
Erfinder: **Boettcher, Andreas, Dr., Breslauer Strasse 24, D-6906 Leimen(DE)**
Erfinder: **Bluemel, Thomas, Dr., An der Bleiche 12a, D-6701 Erpolzheim(DE)**
Erfinder: **Seitz, Friedrich, Dr., Von-Wieser-Strasse 1, D-6701 Friedelsheim(DE)**

EP 0 291 879 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft photopolymerisierbare Aufzeichnungsmaterialien mit mindestens einer photopolymerisierbaren, olefinisch ungesättigten organischen Verbindung, gegebenenfalls einem polymeren Bindemittel, einem Photopolymerisationsinitiator, einem farbbildenden System, bestehend aus Farbbildner und Photooxidationsmittel, sowie einem Sensibilisator. Sie sind insbesondere geeignet für die Herstellung von Photoresistschichten und Flachdruckplatten. Die Erfindung betrifft außerdem neue Chinazolon-4--Verbindungen, die als Sensibilisatoren geeignet sind.

Photopolymerisierbare Aufzeichnungsmaterialien für die genannten Anwendungszwecke sind an sich bekannt. Sie enthalten im allgemeinen neben einer photopolymerisierbaren, olefinisch ungesättigten organischen Verbindung, einem polymeren Bindemittel sowie einem Photopolymerisationsinitiator ein farbbildendes System, welches bei Bestrahlung mit aktinischem Licht in den bestrahlten Bereichen eine Farbänderung bewirkt. Diese Farbänderung ist für die visuelle Beurteilung und Kontrolle der Aufzeichnungsmaterialien nach der bildmäßigen Belichtung von großer Wichtigkeit. So ist es z.B. bei der Herstellung gedruckter Schaltungen oder Leiterplatten mittels Photoresistschichten notwendig, sich nach der bildmäßigen Belichtung und vor der Entfernung der unbelichteten Bereiche der Photoresistschichten zu vergewissern, ob das Negativ richtig aufgelegt war. Ferner ermöglicht die Farbänderung bei der bildmäßigen Belichtung von Schichten aus den photopolymerisierbaren Aufzeichnungsmaterialien eine Kontrolle des erhaltenen Bildes nach der Entwicklung der belichteten Schicht, so daß hierdurch beispielsweise etwaige Ablösungen der Bildteile der Schicht bei der Entwicklung leicht und zuverlässig festgestellt werden können. Um eine möglichst gute visuelle Beurteilung dieser belichteten Schichten vornehmen zu können, soll das farbbildende System bei der Belichtung einen möglichst starken Farbkontrast in den Aufzeichnungsmaterialien bewirken, wobei angestrebt wird, daß durch die Farbbildung möglichst dunkle Bilder bei Betrachtung im Gelblicht erhalten werden. Ferner müssen die farbbildenden Systeme lagerstabil sein, damit in den photopolymerisierbaren Aufzeichnungsmaterialien in der Zeit zwischen Herstellung und Anwendung keine unerwünschte Farbvertiefung auftritt.

Die farbbildenden Systeme bestehen im allgemeinen aus einer farblosen oder schwach gefärbten Farbstoff-Vorstufe (Farbbildner) und einem Aktivator, der bei Bestrahlung mit aktinischem Licht die Farbstoff-Vorstufe in die farbige Verbindung überführt. Als Farbbildner kommen insbesondere Leukofarbstoffe oder die schwach gefärbten freien Basen oder Lactonformen von Farbstoffen in Betracht. Als Aktivatoren für die Farbbildner werden üblicherweise Photooxidationsmittel eingesetzt, wobei hierfür insbesondere organische Halogenverbindungen beschrieben werden, die bei Bestrahlung mit aktinischem Licht Halogenradikale abspalten. Verwiesen sei in diesem Zusammenhang z.B. auf die DE-A-23 06 353, DE-A-27 18 200, EP-B-2805, EP-B-5379 sowie WO-A-80/01846. Es ist auch schon vorgeschlagen worden, als Photooxidationsmittel Hexaarylbisimidazole zu verwenden (vgl. DE-A-19 24 317 sowie EP-B-19219). Die bekannten photopolymerisierbaren Aufzeichnungsmaterialien enthalten darüber hinaus in aller Regel zur Empfindlichkeitssteigerung und Verbesserung der Photoreaktion auch noch einen Sensibilisator, z.B. ein tertiäres Amin einer aromatischen Carbonylverbindung, wie z.B. Michler's Keton.

Die in den bekannten photopolymerisierbaren Aufzeichnungsmaterialien eingesetzten farbbildenen Systeme zeigen bei der bildmäßigen Belichtung dieser Materialien mit aktinischem Licht häufig nur einen schwachen Farbumschlag und einen nicht zufriedenstellenden Kontrast zwischen belichteten und unbelichteten Bereichen. Auch ist die Lagerstabilität der bisher für die photopolymerisierbaren Aufzeichnungsmaterialien verwendeten farbbildenden Systeme vielfach nicht zufriedenstellend, so daß bereits bei der Lagerung im Dunkeln eine Farbvertiefung zu beobachten ist. Die farbbildenden Systeme, die als Aktivator für den Farbbildner eine organische Halogenverbindung enthalten, beeinflussen ferner den Verarbeitungsspielraum der photopolymerisierbaren Aufzeichnungsmaterialien in negativer Weise. So lassen sich Photoresistschichten aus diesen Aufzeichnungsmaterialien beispielsweise nach der bildmäßigen Belichtung und Entwicklung nicht vollständig von metallischen Substraten entfernen, wie es z.B. bei der Herstellung von gedruckten Schaltungen und Leiterplatten erforderlich ist, sondern es verbleibt eine mehr oder weniger stark ausgebildete Restschicht auf dem Substrat, die die Weiterverarbeitung der Produkte stört. Weiterhin kann der Halogengehalt zu Korrosionserscheinungen an metallischen Substraten führen. Es besteht daher ein Bedarf an weiteren, verbesserten farbbildenden Systemen für den Einsatz in photopolymerisierbaren Aufzeichnungsmaterialien der in Rede stehenden Art.

In der DE-A-20 46 018 werden photographische Aufzeichnungsmaterialien beschrieben, in denen auf einen Schichtträger ein Farbbildner-System aufgetragen ist. Diese photographischen, nicht photopolymerisierbaren Aufzeichnungsmaterialien dienen zur Herstellung von gefärbten Bildern. Ihr Farbbildner-System besteht aus einem farblosen oder praktisch farblosen Farbbildner, der oxidativ in die gefärbte Form überführt werden kann, sowie einer heterocyclischen Verbindung mit einem durch einen Acyloxy- oder Alkoxy-Rest substituierten Ringstickstoffatom als Photooxidationsmittel. Als Farbbildner werden Leukofarbstoffe und deren Derivate beschrieben. Als Photooxidationsmittel sind insbesondere speziell substituierte N-Alkoxy- bzw. N-Acyloxy-pyridinium-Salze genannt. Die in der DE-A-20 46 018 beschriebenen photographischen Aufzeichnungsmaterialien zeigen bei Belichtung mit aktinischem Licht nur einen relativ schwachen Farbumschlag bzw. benötigen für die Erzielung eines stärkeren Kontrastes zwischen belichteten und unbelichteten Bereichen wesentlich längere Belichtungszeiten, als sie für photopolymerisierbare Aufzeichnungsmaterialien akzeptierbar sind.

Ein weiterer Nachteil bekannter photopolymerisierbarer Aufzeichnungsmaterialien, bei denen Hexaarylbisimidazolyle als photoaktive Verbindungen zum Einsatz kommen, ist in dem starken Fluoreszenzverhalten der als Sensibilisator verwendeten Zusatzstoffe zu sehen, wie sie beispielsweise in der EP-A-138 187 beschrieben sind. Photoresistschichten aus derartigen Aufzeichnungsmaterialien zeigen deutlich verringertes Auflösungsvermögen, so daß feine Leiterbahnstrukturen nicht mehr befriedigend reproduziert werden können.

Aufgabe der vorliegenden Erfindung war es, photopolymerisierbare Aufzeichnungsmaterialien mit einem guten Farbbildner-System aufzuzeigen, die die Nachteile der bisher bekannten Produkte überwinden, d.h. die einfach und leicht erhältlich sind, bei den für die photopolymerisierbaren Aufzeichnungsmaterialien geforderten relativ kurzen Belichtungszeiten mit aktinischem Licht einen großen Farbumschlag unter Ausbildung eines scharfen und starken Kontrastes zwischen belichteten und unbelichteten Bereichen liefern, gute Lagerstabilität besitzen sowie auf metallischen Substraten keine Restschicht bilden.

Als im farbbildenden System der photopolymerisierbaren Aufzeichnungsmaterialien enthaltene Sensibilisatoren im weiteren Sinne kommen Verbindungen in Betracht, die bei Bestrahlung der photopolymerisierbaren Aufzeichnungsmaterialien mit aktinischem Licht das aktinische Licht zu absorbieren und die Anregungsenergie oder Elektronen auf die photochemisch aktiven Verbindungen, das sind das Photooxidationsmittel und der Photopolymerisationsinitiator, zu übertragen vermögen und dadurch die photochemischen Reaktionen in den photopolymerisierbaren Aufzeichnungsmaterialien bei deren Bestrahlung mit aktinischem Licht aktivieren.

Es wurde überraschenderweise gefunden, daß diese Aufgabe mit photopolymerisierbaren Aufzeichnungsmaterialien der eingangs beschriebenen Art gelöst wird, wenn man eine als Photoinitiator und/oder Photooxidationsmittel wirkende Substanz zusammen mit bestimmten Chinazolon-4-Verbindungen als Sensibilisator verwendet.

Gegenstand der vorliegenden Erfindung sind photopolymerisierbare Aufzeichnungsmaterialien mit mindestens einer photopolymerisierbaren, olefinisch ungesättigten organischen Verbindung, gegebenenfalls einem polymeren Bindemittel, mindestens einem Photopolymerisationsinitiator, einem farbbildendem System, welches bei Bestrahlung mit aktinischem Licht eine Zunahme der Farbintensität der Aufzeichnungsmaterialien bewirkt, einem Sensibilisator sowie gegebenenfalls weiteren Zusatz- und/oder Hilfsstoffen, die dadurch gekennzeichnet sind, daß sie als Sensibilisatoren wenigstens eine Verbindung der allgemeinen Formel I

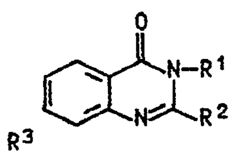

(I)

enthalten, in der

$R^1$ für $C_1$- bis $C_{12}$-Alkyl, Cycloalkyl, Phenyl, durch Halogen, $C_1$- bis $C_{12}$-Alkyl, Nitril, Trifluormethyl, $C_1$- bis $C_{12}$-Alkoxy, -O-CO-$C_1$- bis -$C_{12}$-Alkyl, -CO-O-$C_1$- bis -$C_{12}$-Alkyl oder $NR^4R^5$ substituiertes Aryl oder Heteroaryl steht, wobei $R^4$ und $R^5$ untereinander gleich oder verschieden sind und für $C_1$-bis $C_8$-Alkyl, Aryl-$C_1$- bis -$C_6$-alkyl, wobei der Arylrest durch Halogen, $C_1$- bis $C_6$-Alkyl oder $C_1$- bis $C_6$-Alkoxy ein oder mehrfach substituiert sein kann, für gegebenenfalls durch $C_1$- bis $C_6$-Alkyl, $C_1$-bis $C_6$-Alkoxy, Nitril, Trifluormethyl und/oder Halogen ein- oder mehrfach substituiertes Phenyl für gegebenenfalls durch OH, Halogen, CN, -O-CO-$C_1$- bis -$C_6$-Alkyl oder -CO-O-$C_1$- bis -$C_6$-alkyl-substituiertes $C_1$- bis $C_{12}$-Alkyl oder Oxaalkyl mit 3 bis 12 Kohlenstoffatomen und 1 bis 5 Sauerstoffatomen stehen oder $R^4$ und $R^5$ zusammen ein gesättigtes oder ungesättigtes heterocyclisches Ringsystem bilden;

$R^2$ für $C_1$- bis $C_{12}$-Alkyl, Cycloalkyl, Phen-$C_1$ bis $C_6$-Alkyl, für Aryl oder Heteroaryl oder für durch $C_1$- bis $C_{12}$-Alkyl, das durch OH, Halogen, CN, -O-CO-$C_1$- bis -$C_6$-Alkyl oder -CO-O-$C_1$- bis -$C_6$-Alkyl substituiert sein kann, $C_1$- bis $C_6$-Alkoxy, OH, Halogen, CN oder -O-CO-$C_1$- bis $C_6$-Alkyl, -CO-O-$C_1$- bis -$C_6$-Alkyl, Oxaalkyl mit 2 bis 12 Kohlenstoffatomen und 1 bis 6 Sauerstoffatomen oder durch $NR^6R^7$ substituiertes Aryl oder Heteroaryl steht, wobei $R^6$ und $R^7$ unter einander gleich oder verschieden sind und $C_1$- bis $C_8$-Alkyl, Allyl, Aryl-$C_1$-bis $C_6$-alkyl, wobei der Arylrest durch Halogen, $C_1$- bis $C_6$-Alkyl oder $C_1$- bis $C_6$-Alkoxy ein- oder mehrfach substituiert sein kann, für Phenyl oder durch $C_1$- bis $C_6$-Alkyl, $C_1$-bis $C_6$-Alkoxy und/oder Halogen ein- oder mehrfach substituiertes Phenyl, für durch OH, Halogen, CN, -O-CO-$C_1$- bis -$C_6$-Alkyl, oder -CO-O-$C_1$- bis $C_6$-alkylsubstituiertes $C_1$- bis $C_{12}$-Alkyl oder Oxaalkyl mit 3 bis 12 Kohlenstoffatomen und 1 bis 5 Sauerstoffatomen stehen oder $R^6$ und $R^7$ zusammen ein heterocyclisches gesättigtes oder ungesättigtes Ringsystem bilden und

R3für Wasserstoff, $C_1$- bis $C_{12}$-Alkyl, $C_1$- bis $C_{12}$-Alkoxy, durch OH, Halogen, CN, -O-CO-$C_1$-bis -$C_6$-Alkyl substituiertes $C_1$- bis $C_{12}$-Alkyl oder Oxalkyl mit 2 bis 12 Kohlenstoffatomen und 1 bis 5 Sauerstoffatomen, Halogen, Trialkylsilyl oder Perfluor-$C_1$- bis -$C_7$-alkyl steht mit der Maßgabe, daß das Maximum der langwelligen Absorptionsbande dieser Verbindungen unter 420 nm, vorzugsweise unter 400 nm liegt.

Bevorzugt als Sensibilisatoren sind Verbindungen der Formel (I), worin $R^1$ und $R^2$ für wie oben definierte Arylreste und $R^3$ für Wasserstoff stehen, sowie Verbindungen der Formel (I), worin $R^1$ für einen wie oben substituierten Phenyl- oder Benzylrest und $R^2$ für einen durch $NR^6R^7$ substituierten Arylrest stehen, wobei $R^6$ und $R^7$ die oben genannte Bedeutung haben.

Als farbbildendes System, welches bei Bestrahlung mit aktinischem Licht eine Zunahme der Farbintensität der erfindungsgemäßen Aufzeichnungsmaterialien bewirkt, ist im allgemeinen (a) mindestens eine farblose oder praktisch farblose organische Verbindung, die zu einer farbigen Verbindung oxidierbar ist, vorzugsweise ein Leukofarbstoff, insbesondere ein Triarylmethanfarbstoff in seiner Leukoform, und (b) ein Photooxidationsmittel für die farblose oder praktisch farblose organische Verbindung (a) enthalten.

Bevorzugt sind solche photopolymerisierbaren Aufzeichnungsmaterialien, die als Photopolymerisationsinitiator und/oder Photooxidationsmittel ein Hexaarylbisimidazolyl oder als Photooxidationsmittel ein N-Alkoxypyridiniumsalz enthalten.

Gegenstand der vorliegenden Erfindung sind auch Photoresistschichten und Flachdruckplatten auf Basis der erfindungsgemäßen photopolymerisierbaren Aufzeichnungsmaterialien.

Gegenstand der vorliegenden Erfindung sind außerdem Chinazolon-4-Verbindungen der allgemeinen Formel

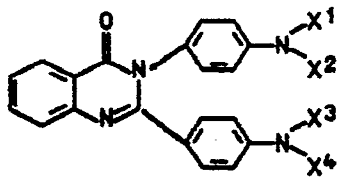

worin $X^1$, $X^2$, $X^3$ und $X^4$ untereinander gleich oder verschieden sind und für Kohlenwasserstoffreste mit 1 bis 12 Kohlenstoffatomen stehen, die durch OH, CN, Halogen, Phenyl, $-O-CO-C_1$- bis $C_6$-Alkyl, $-CO-O-C_1$- bis $-C_8$-Alkyl oder Oxaalkyl mit 3 bis 12 Kohlenstoffatomen und 1 bis 5 Sauerstoffatome substituiert sein können. Bevorzugt stehen die Reste $X^1$ bis $X^4$ für Alkylreste mit 1 bis 4 Kohlenstoffatomen. Besonders bevorzugt sind neue Chinazolon-4-Verbindungen, in denen die Reste $X^1$ bis $X^4$ für Methyl- oder Ethylgruppen stehen.

Diese Chinazolon-4-Verbindungen können nach an sich bekannten Verfahren der organischen Chemie hergestellt werden, beispielsweise aus einem geeignet substituierten Isatosäureanhydrid durch Umsetzung mit einem aromatischen Amin in einem inerten Lösungsmittel.

Zu den einzelnen Aufbaukomponenten der erfindungsgemäßen photopolymerisierbaren Aufzeichnungsmaterialien ist folgendes auszuführen.

Erfindungsgemäß kommen als Sensibilisatoren Verbindungen der allgemeinen Formel (I) in Betracht

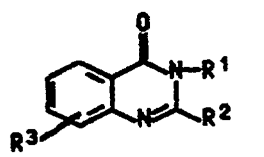

(I)

worin

$R^1$ für einen $C_1$- bis $C_{12}$-Alkyl-Rest, wie z.B. einen Methyl-, Ethyl-, n-Propyl-, Isopropyl-, n-Butyl-, Isobutyl- oder tert.-Butylrest, für einen Cycloalkylrest, wie z.B. einen Cyclohexylrest, für einen Phenylrest, für einen durch Halogen, wie z.B. Fluor, Chlor oder Brom, durch einen $C_1$- bis $C_{12}$-Alkylrest, wie z.B. einem Methyl-, Ethyl-, Propyl-, n-Butyl-, Isobutyl-, tert. Butyl-, Hexyl- oder Octylrest, durch einen $C_1$-bis $C_{12}$-Alkoxyrest, z.B. einen Methoxy-, Ethoxy-, Propoxy-, Butoxyrest, durch einen Nitrilrest, einen Trifluormethylrest, einen $-O-CO-C_1$- bis $-C_{12}$-Alkylrest z.B. einen Acetoxy- oder Propionoxyrest, einen $-CO-O-C_1$- bis $-C_{12}$-Alkylrest oder durch eine $NR^4R^5$-Gruppe substituierten Aryl- oder Heteroarylrest, wie z.B. einen Phenylrest steht, worin $R^4$ und $R^5$ untereinander gleich oder verschieden sind und für $C_1$- bis $C_8$-Alkylreste, z.B. Methyl-, Ethyl-, Propyl-, Butylreste, Aryl-$C_1$- bis $-C_6$-alkylreste, z.B. Benzyl-oder Phenylethylreste, wobei der Arylrest durch Halogen, wie z.B. Fluor, Chlor oder Brom, $C_1$- bis $C_6$-Alkyl, wie z.B. Methyl, Ethyl, Propyl oder Butyl, oder $C_1$- bis $C_6$-Alkoxy, wie z.B. Methoxy, Ethoxy, Propoxy oder Butoxy, ein- oder mehrfach substituiert sein kann, oder für gegebenenfalls durch $C_1$-bis $C_4$-Alkylreste, wie z.B. Methyl-, Ethyl-, Propyl- oder Butylreste, $C_1$-bis $C_6$-Alkoxyreste, wie z.B. Methoxy-, Ethoxy-, Propoxy- oder Butoxyreste, Nitril, Trifluormethyl und/oder Halogen, wie z.B. Fluor, Chlor oder Brom ein- oder mehrfach substituierte Phenylreste, für gegebenenfalls durch OH, Halogen, wie Fluor, Chlor oder Brom, CN, $-O-CO-C_1$-bis $-C_6$-Alkyl, wie z.B. Acetoxy oder Propionoxy, oder $-CO-O-C_1$-bis $-C_6$-alkylsubstituiertes $C_1$- bis $C_{12}$-Alkyl oder Oxaalkyl mit 3 bis 12 Kohlenstoffatomen und 1 bis 5 Sauerstoffatomen, wie z.B. $-CH_2-CH_2-O-CH_3$, $-CH_2-CH_2-O-C_2H_5$, $-(CH_2)_2-O-C_3H_7$, $-C_3H_8-O-CH_3$, $-C_3H_6-O-C_3H_7$, $-(CH_2)_2-O-(CH_2)_2-O-CH_3$, oder $-(CH_2)_2-O-(CH_2)_2-O-C_2H_5$ stehen oder $R^4$ und $R^5$ miteinander zu einem fünf-oder sechsgliedrigen heterocyclischen gesättigten oder ungesättigten N-haltigen Ringsystem, wie z.B. ein Julolidin-, Pyrazolin-, Carbazol-, Morpholin-, Piperidin- oder N-Alkylpiperazinrest verbunden sind;

$R^2$für einen $C_1$- bis $C_{12}$-Alkylrest, wie z.B. einen Methyl-, Ethyl-, Propyl-, n-Butyl-, Isobutyl-, tert.-Butyl-, Hexyl-, Octyl- oder Decylrest, einen Cycloalkylrest, wie z. B. einen Cyclohexylrest, für einen Phen-$C_1$- bis -$C_6$-alkylrest wie z.B. Benzylrest, für Aryl oder Heteroaryl, wie z.B. Phenyl, Naphthyl, Biphenyl, Pyridyl, Furanyl, Thienyl, oder durch $C_1$- bis $C_{12}$-Alkyl wie z.B. Methyl, Ethyl, n-Propyl, Isopropyl, n-Butyl, Isobutyl oder tert.-Butyl, wobei dieses $C_1$- bis $C_{12}$-Alkyl durch OH, Halogen, wie z.B. Fluor, Chlor, Brom, CN, -O-CO-$C_1$- bis -$C_6$-Alkyl oder -CO-O-$C_1$- bis -$C_6$-Alkyl substituiert sein kann, durch $C_1$- bis $C_6$-Alkoxy, wie z.B. Methoxy, Ethoxy, Propoxy oder Butoxy, Halogen, wie Fluor, Chlor oder Brom, OH, CN, -O-CO-$C_1$- bis -$C_6$-Alkyl oder -CO-O-$C_1$-bis -$C_6$-Alkyl oder Oxaalkyl mit 2 bis 12 Kohlenstoffatomen und 1 bis 6 Sauerstoffatomen, wie z.B. $-CH_2-O-CH_3$, $-CH_2-O-C_2H_5$, $-CH_2-O-C_3H_7$, $-CH_2-CH_2-O-CH_3$, $-CH_2-CH_2-O-C_2H_5$, $-(CH_2)_2-O-C_3H_7$, $-C_3H_6-O-CH_3$, $-C_3H_6-O-C_3H_7$, $-(CH_2)_2-O-(CH_2)_2-O-CH_3$ oder $-(CH_2)_2-O-(CH_2)_2-O-C_2H_5$ oder durch $NR^6R^7$ substituiertes Aryl oder Heteroaryl steht, wobei $R^6$ und $R^7$ untereinander gleich oder verschieden sind und für $C_1$- bis $C_8$-Alkyl, Allyl, Aryl-$C_1$- bis -$C_6$-alkyl, wobei der Arylrest ein Phenyl-, Naphthyl oder Biphenylrest sein kann und durch Halogen, wie z.B. Fluor, Chlor oder Brom, $C_1$- bis $C_6$-Alkyl, wie z.B. Methyl, Ethyl, Propyl oder Butyl oder $C_1$- bis $C_6$-Alkoxy, wie z.B. Methoxy, Ethoxy, Propoxy oder Butoxy, ein- oder mehrfach substituiert sein kann, für Phenyl oder durch $C_1$- bis $C_6$-Alkyl, wie z.B. Methyl, Ethyl, Propyl oder Butyl, $C_1$- bis $C_6$-Alkoxy, wie z.B. Methoxy, Ethoxy, Propoxy oder Butoxy und/oder Halogen, wie z.B. Fluor, Chlor oder Brom, ein- oder mehrfach substituiertes Phenyl, für durch OH, Halogen, wie z.B. Fluor, Chlor oder Brom, CN, -O-CO-$C_1$- bis -$C_6$-Alkyl, oder -CO-O-$C_1$- bis -$C_6$-alkylsubstituiertes $C_1$- bis $C_{12}$-Alkyl oder Oxaalkyl mit 3 bis 12 Kohlenstoffatomen und 1 bis 5 Sauerstoffatomen, wie z.B. $-(CH_2)_2-O-CH_3$, $-(CH_2)_2-O-C_2H_5$, $-(CH_2)_2-O-C_3H_7$, $-C_3H_6-O-CH_3$, $-C_3H_6-O-C_2H_5$, $-C_3H_6-O-C_3H_7$, $-(CH_2)_2-O-(CH_2)_2O-CH_3$, $-(CH_2)_2-O-(CH_2)_2O-(CH_2)_2-O-C_2H_5$ oder $-(CH_2)_2-O-(CH_2)_2-O-C_2H_5$ stehen oder $R^6$ und $R^7$ zusammen ein heterocyclisches gesättigtes oder ungesättigtes Ringsystem, wie z.B. einen Julolidin-, Pyrazolin-, Carbazol-, Morpholin-, Piperidin- oder N-Alkylpiperazinrest bilden und

$R^3$ für Wasserstoff, $C_1$- bis $C_{12}$-Alkyl, wie z.B. Methyl, Ethyl, n-Propyl, Isopropyl, n-Butyl, Isobutyl oder tert.-Butyl, $C_1$- bis $C_{12}$-Alkoxy, wie z.B. Methoxy, Ethoxy, Propoxy oder Butoxy, durch OH, Halogen, wie z.B. Fluor, Chlor oder Brom, CN, -O-CO-$C_1$- bis -$C_6$-Alkyl oder -CO-O-$C_1$- bis -$C_6$-Alkyl substituiertes $C_1$- bis $C_{12}$-Alkyl oder Oxaalkyl mit 2 bis 12 Kohlenstoffatomen und 1 bis 5 Sauerstoffatomen, Trialkylsilyl mit 1 bis 4 C-Atomen in der Alkylgruppe, wie z.B. Trimethylsilyl oder Perfluor-$C_1$- bis -$C_7$-alkyl, wie z.B. Trifluormethyl steht,

mit der Maßgabe, daß das Maximum der langwelligen Absorptionsbande dieser Verbindungen unter 420 nm, vorzugsweise unter 400 nm liegt.

Bevorzugte Sensibilisatoren für die erfindungsgemäßen photopolymerisierbaren Aufzeichnungsmaterialien sind solche der allgemeinen Formel (I), worin $R^1$ für einen wie oben definierten Arylrest, insbesondere einen substituierten Phenyl- oder Benzylrest, $R^2$ für einen wie oben definierten substituierten Arylrest, insbesondere einen durch $NR^6R^7$ substituierten Phenylrest und $R^3$ für einen $C_1$- bis $C_6$-Alkylrest, einen $C_1$- bis $C_6$-Alkoxyrest oder insbesondere Wasserstoff stehen.

Als Beispiele für geeignete und ganz besonders bevorzugte Sensibilisatoren seien genannt:

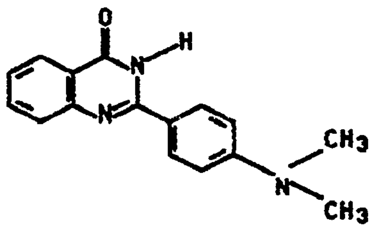

(II)

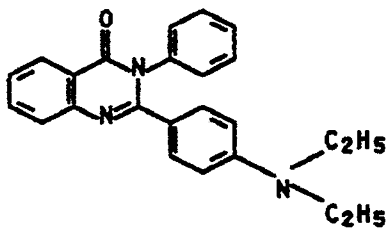

(III)

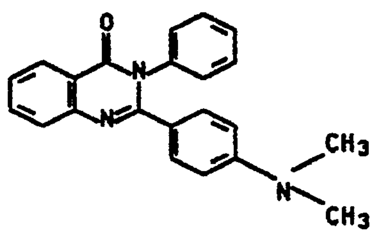

(IV)

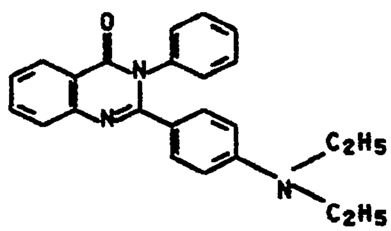

(V)

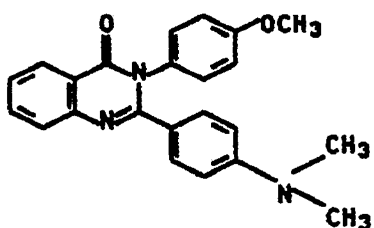

(VI)

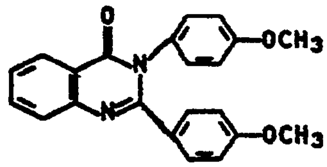

(VII)

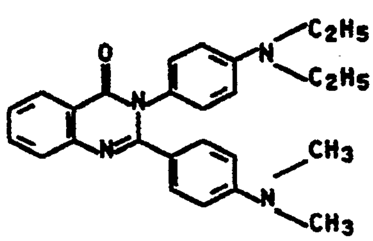

(VIII)

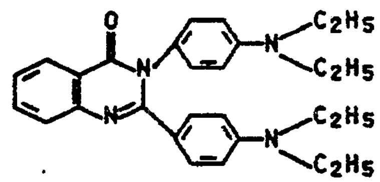

(IX)

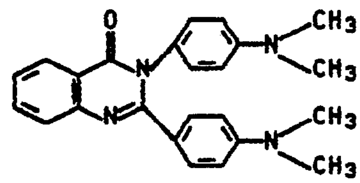

(X)

Der erfindungsgemäße Einsatz der Sensibilisatoren der vorstehend beschriebenen Art im farbbildenden System mit Photooxidationsmitteln b) bewirkt überraschenderweise in den erfindungsgemäßen photopolymerisierbaren Aufzeichnungsmaterialien eine sehr starke Vertiefung der Farbintensität und Kontrastbildung schon bei den relativ kurzen Belichtungszeiten mit aktinischem Licht, wie sie für die photopolymerisierbaren Aufzeichnungsmaterialien gefordert werden.

Die erfindungsgemäß als Sensibilisatoren wirkenden Verbindungen sind teilweise an sich bekannt (z.B. GB-A 2 068 994) oder können in Anlehnung an in der Literatur beschriebene Verfahren hergestellt werden, beispielsweise durch Erhitzen eines N-Benzoylanthranilsäureanilids in einem dehydratisierenden Medium, wie Acetanhydrid oder Benzoylchlorid,

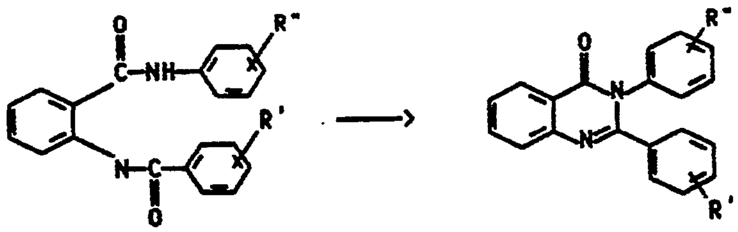

wie es in J. Gen. Chem. USSR 30 (1960) 2352 beschrieben ist, oder einfacher durch Umsetzung von aus entsprechenden Anthranilsäurederivaten zugänglichen Benzoxazinonen mit den entsprechenden Aminen in einem geeigneten Lösungsmittel wie z.B. Pyridin,

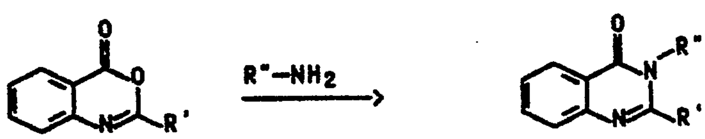


wie es z.B. in J. Heterocycl. Chem. 17 (1980) 1065 beschrieben ist.

Die Sensibilisatoren werden im allgemeinen in Mengen von 0,01 bis 10, vorzugsweise 0,1 bis 1 Gew.-%, bezogen auf die photopolymerisierbare Masse, eingesetzt.

Als im farbbildenden System der erfindungsgemäßen photopolymerisierbaren Aufzeichnungsmaterialien enthaltene Photooxidationsmittel (b) kommen insbesondere

b1) Hexarylbisimidazolyle der Formel (XI) oder einer strukturisomeren Form

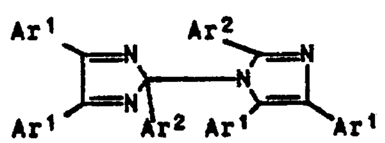

(XI)

worin $Ar^1$ und $Ar^2$ die unten angegebene Bedeutung haben, oder

b2) heteroaromatische salzartige Systeme mit mindestens einer Gruppierung der Formel (XII) in Betracht.

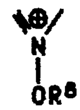

(XII)

Der Begriff "salzartige Systeme" schließt dabei auch innere Salze ein, d.h. ionische Verbindungen, bei denen die kationischen und anionischen Gruppen durch kovalente Bindungen miteinander verknüpft sind. Als heteroaromatisches System in diesen Salzen, welches mindestens eine Gruppierung der oben angegebenen allgemeinen Formel (XII) enthält, kommen insbesondere sechsgliedrige heteroaromatische Ringe mit ein, zwei oder auch drei Ringstickstoffatomen, deren kernsubstituierte Derivate, einschließlich der benzanellierten und hetarylanellierten Vertreter in Betracht.

Durch geeignete Wahl der Kernsubstitution in den Resten Ar der Formel (XI) bzw. in dem heteroaromatischen System sowie des Restes $R^8$ in der Gruppierung der allgemeinen Formel (XII) lassen sich die Aktivität bei Bestrahlung mit aktinischem Licht und die Stabilität der Photooxidationsmittel (b) beeinflussen und variieren. Darüber hinaus haben auch die Anionen in den Photooxidationsmitteln (b2) einen Einfluß auf die Eigenschaften der photopolymerisierbaren Aufzeichnungsmaterialen. Üblicher- und vorteilhafterweise wird das Photooxidationsmittel (b) so ausgewählt, daß dessen molarer Extinktionskoeffizient $\varepsilon$ im Wellenlängenbereich von 300 bis 420 nm, insbesondere im Bereich von 320 bis 400 nm, kleiner ist als der des in den erfindungsgemäßen photopolymerisierbaren Aufzeichnungsmaterialien mitverwendeten Sensibilisators für das Photooxidationsmittel (b) sowie gegebenenfalls des Sensibilisators für den Photopolymerisationsinitiator.

Bei den Photooxidationsmitteln (b1) handelt es sich gemäß Formel (XI) um 2,4,5-Triarylimidazol-Dimere, bei denen zwei Imidazolreste durch eine kovalente Bindung verknüpft sind, wobei $Ar^1$ für einen substituierten oder unsubstituierten Phenylrest, vorzugsweise für einen in 4-Position durch einen mit $C_1$-$C_6$-Alkyl oder $C_1$-$C_6$-Alkoxy substituierten Phenylrest und $Ar^2$ für einen Phenyl oder vorzugswseise für einen in der 2-oder 2′-Position durch Halogen, wie F, Cl, Br oder einen Alkylrest substituierten Phenylrest steht. Aus dem 2,4,5-Triarylimidazol-Dimeren entstehen durch Licht- und/oder Wärmeeinwirkung die eigentlichen Photooxidationsmittel, die Triarylimidazolyl-Radikale.

Besonders bevorzugt sind das 2,2′-Bis(o-chlorphenyl)-4,4′,5,5′-tetraphenylbisimidazolyl und das 2,2′-Bis(o-chlorphenyl)-4,4′,5,5′-tetra(p-methoxyphenyl)bisimidazolyl.

Diese Hexaarylbisimidazolyle sind an sich bekannt oder lassen sich leicht nach Methoden darstellen, wie sie beispielsweise in J. Org. Chem. 36, 2262 (1971) beschrieben sind.

Zu den Photooxidationsmitteln (b2) gehören insbesondere die Pyridinium-, Pyrazinium- und Pyrimidinium-Salze, die im heteroaromatischen Ring eine Gruppierung der oben angegebenen allgemeinen Formel (XII) eingebaut enthalten, ferner die kernsubstituierten Derivate dieser Salze, die einen oder mehrere Kernsubstituenten der oben angegebenen Art im heteroaromatischen Ring enthalten, sowie auch anellierte Derivate dieser Salze, wie z.B. benzanellierte Pyridinium-Salze der in Rede stehenden Art, wie etwa die entsprechenden, gegebenenfalls kernsubstituierten Chinolinium-, Isochinolinium- oder Phenanthridinium-Salze. In der allgemeinen Formel (XII) für Photooxidationsmittel (b2) kann $R^8$ für einen gegebenenfalls substituierten Alkyl- und Aryl-Rest, sowie für einen Cycloalkyl-Rest stehen. Weitere Photooxidationsmittel sind in der deutschen Patentanmeldung P O.Z. 0050/39193 im einzelnen angeführt. Bevorzugt für den Rest $R^8$ in der Gruppierung der allgemeinen Formel (XII) sind Alkyl- und Aryl-Reste, insbesondere Alkyl-Gruppen mit 1 bis 6 C-Atomen. Zu den bevorzugten Kernsubstituenten für diese Salze gehören insbesondere die, gegebenenfalls substituierten, Alkyl-Reste.

Als Anionen für diese Salze sind u.a. bevorzugt Benzolsulfonat-, Tosylat-, Alkylsulfonat-, Trifluormethansulfonat- oder Tetrafluoroborat-Anionen. Als besonders vorteilhaft für den erfindungsgemäßen Einsatz haben sich dabei die N-Alkoxy- und N-Aryloxy-pyridiniumsalze, die N-Alkoxy- und N-Aryloxypicoliniumsalze als auch die N-Alkoxy- und N-Aryloxy-lutidiniumsalze erwiesen.

Zu den Photooxdiationsmitteln (b2) gehören beispielsweise Verbindungen der nachstehend angegebenen allgemeinen Formeln (XIII) bis (XXI)

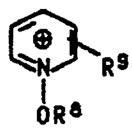 $A^{\ominus}$ (XIII)

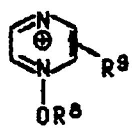 $A^{\ominus}$ (XIV)

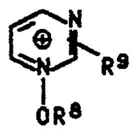 $A^{\ominus}$ (XV)

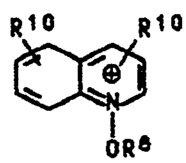 $A^{\ominus}$ (XVI)

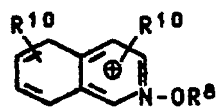 $A^{\ominus}$ (XVII)

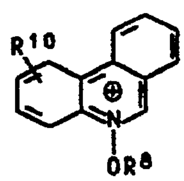 $A^{\ominus}$ (XVIII)

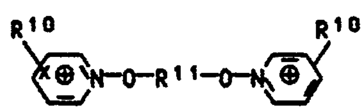 $2A^{\ominus}$ (XIX)

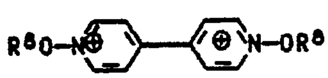 $2A^{\ominus}$ (XX)

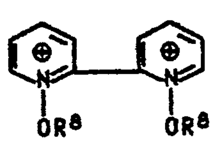 $2A^{\ominus}$ (XXI)

In diesen Formeln (XIII) bis (XXI) bedeutet der Rest $R^8$ vorzugsweise einen Alkyl- oder Aryl-Rest, insbesondere einen Alkylrest mit 1 bis 6 C-Atomen, wie die Methyl-, Ethyl- oder i-Propyl-Gruppe. Der Rest $R^{10}$ bedeutet in diesen Formeln Wasserstoff (entsprechend einem unsubstituierten heteroaromatischen Ring) oder einen oder mehrere Kernsubstituenten der vorstehend angegebenen Art. Vorzugsweise steht $R^{10}$ für Wasserstoff oder eine oder mehrere, gegebenenfalls substituierte, Alkylgruppen, Arylgruppen, Alkoxygruppen oder Chlor. Insbesondere stellt $R^{10}$ ein Wasserstoffatom oder eine oder mehrere Methylgruppen, vorzugsweise 2-Methyl, 2,6-Dimethyl, oder in den allgemeinen Formeln (XIII), (XIV) und (XIX), auch 3,5-Dimethyl dar. In Formel (XIX) steht $R^{11}$ für einen Alkyliden-Rest, insbesondere mit 2 bis 6 C-Atomen, oder einen Xyliden-Rest, z.B. den p-Xyliden-Rest. Ferner steht in den Formeln (XIII) bis (XXI) $A^{\ominus}$ für ein Säureanion, insbesondere der weiter oben angegebenen Art. Bevorzugte Säureanionen für die Verbindungen der allgemeinen Formeln (XIII) bis (XXI) sind das Benzolsulfonat-, Toluolsulfonat-, Methylsulfonat-, n-Octylsulfonat-, Tetrafluoroborat- und Trifluormethansulfonat-Anion. Für den Fall, daß einer der Reste $R^8$ oder $R^{10}$ eine Anionen-Gruppierung, z.B. eine Sulfonat-Gruppe, enthält, entfällt selbstverständlich das Anion in den allgemeinen Formeln (XIII) bis (XXI).

Unter den als Photooxidationsmittel (b) einzusetzenden Salzen kommen den Verbindungen der allgemeinen Formel (XIII) besondere Bedeutung zu, wobei sich hier speziell die Verbindungen als besonders vorteilhaft erwiesen haben, in denen der Rest $R^{10}$ ein Wasserstoffatom oder eine bzw. zwei Methylgruppen und der Rest $R^8$ eine Alkylgruppe mit 1 bis 3 C-Atomen, wie Methyl, Ethyl oder i-Propyl, darstellt.

Als Beispiele für Verbindungen, die erfindungsgemäß als Photooxidationsmittel (b2) in den photopolymerisierbaren Aufzeichnungsmaterialien eingesetzt werden können, seien genannt: N-Methoxy-2-picolinium-bromid, N-Methoxy-2-picolinium-methylsulfat, N-Methoxy-2-picolinium-methansulfonat, N-Methoxy-2-picolinium-trifluormethansulfonat, N-Methoxy-2-picolinium-n-octylsulfonat, N-Methoxy-2-picolinium-o/p-dodecylbenzolsulfonat, N-Methoxy-2-picolinium-hexachloroantimonat, N-Methoxy-2-picolinium-n-pentylsulfonat, N-Ethoxy-2-picolinium-bromid, N-Ethoxy-2-picolinium-n-pentylsulfonat, N-Ethoxy-2-picolinium-n-octylsulfonat, N-Ethoxy-2-picolinium-p-toluolsulfonat, N-Ethoxy-2-picolinium-tetrafluoroborat, N-Ethoxy-2-picolinium-hexafluorophosphat, N-Ethoxy-2-picolinium-hexachloroantimonat, N-Isopropoxy-2-picolinium-p-toluolsulfonat, O-(2'-Picolinium-1'-yl)-3-hydroxy-propansulfonat, N-Ethoxy-3-picolinium-n-pentylsulfonat, N-Ethoxy-3-picolinium-n-octylsulfonat, N-Methoxy-4-picolinium-methansulfonat, N-Methoxy-4-picolinium-n-octylsulfonat, N-Methoxy-4-picolinium-p-toluolsulfonat, N-Ethoxy-4-picolinium-n-pentylsulfonat, N-Ethoxy-4-picolinium-n-octylsulfonat, N-Ethoxy-4-methoxy-pyridinium-tetrafluoroborat, 1,4-Dimethoxy-pyridinium-tetrafluoroborat, N-tert.-Butoxy-pyridinium-perchlorat, N-Methoxy-3,5-lutidinium-p-toluolsulfonat, N-Methoxy-2,6-lutidinium-bromid, N-Methoxy-2,6-lutidinium-trifluormethansulfonat, N-Methoxy-2,6-lutidinium-p-toluolsulfonat, N-Methoxy-2,6-lutidinium-hexachloroantimonat, N-Ethoxy-2,5-lutidinium-tetrafluoroborat, N-Ethoxy-2,6-lutidinium-hexachloroantimonat, N-Ethoxy-2,6-lutidinium-hexafluorophosphat, O-(2',6'-Lutidinium-1'-yl)-3-hydroxy-propansulfonat, N-Methoxy-2-styrylpyridinium-p-toluolsulfonat und N,N'-p-Xylylenoxy-bis-(2-methyl-pyridinium-dibromid.

Die als Photooxidationsmittel (b2) einzusetzenden Salze der vorstehend beschriebenen Art lassen sich nach üblichen und gängigen, literaturbekannten Verfahren oder in Analogie zu diesen herstellen. Verwiesen sei in diesem Zusammenhang z.B. auf R.A. Abramovitch und E.M. Smith in "Pyridine and its Derivatives", Vol. 14 Supplement, Part 2, Seite 1 ff, J. Wiley, New York (1974).

Das in den erfindungsgemäßen photopolymerisierbaren Aufzeichnungsmaterialien enthaltene farbbildende System, welches bei Bestrahlung der Aufzeichnungsmaterialien mit aktinischem Licht eine Zunahme der Farbintensität in diesen Materialien bewirkt, enthält neben den Photooxidationsmitteln (b) der vorstehend beschriebenen Art mindestens eine farblose oder praktisch farblose organische Verbindung (a), die zu einer farbigen Verbindung oxidierbar ist. Diese farbbildende, zunächst farblose oder praktisch farblose organische Verbindung (a) wird im folgenden auch als Farbbildner bezeichnet. Als Farbbildner (a) kommen insbesondere Leukofarbstoffe in Betracht, wobei unter Leukofarbstoff die reduzierte Form eines Farbstoffes verstanden wird, die im allgemeinen 1 bis 2 Wasserstoffatome aufweist, deren Entfernung gemeinsam mit einem oder zwei Elektronen zur Erzeugung des Farbstoffes führt. Diese Leukofarbstoffe sind im wesentlichen farblos oder weisen allenfalls eine geringe, wenig intensive Färbung auf, die von der Farbe des eigentlichen Farbstoffs (oxidierte Form) deutlich verschieden ist. Geeignete Leukofarbstoffe sind insbesondere die Diarylmethan- und Triarylmethan-Farbstoffe in ihrer Leukoform bzw. Farbstoffe mit einer Triarylmethan-Grundstruktur, bei denen zwei der Arylreste über ein N-, S-oder O-Atom miteinander verknüpft sind, in ihrer Leukoform. Hierzu gehören u.a. die Leukoform der Aminoacridin-Farbstoffe, der Aminoxanthen-Farbstoffe und der Aminothioxanthen-Farbstoffe. Geeignet sind ebenfalls Leukofarbstoffe des Triarylmethan-Typs, bei denen ein Dialkyl-bzw. Alkylaryl-aminophenylrest durch eine N-Alkyl-substituierte Carbazolyl-Gruppe ersetzt ist. Ferner können als Farbbildner (a) beispielsweise auch Leukomethine eingesetzt werden. Leukofarbstoffe, die als Farbbildner (a) für die erfindungsgemäßen photopolymerisierbare Aufzeichnungsmaterialien geeignet sind, sind beispielsweise in der US-A-3 552 973 beschrieben. Von besonderem Interesse sind dabei die Leukotriarylmethanfarbstoffe, wie z.B. Leukokristallviolett, Leukomalachitgrün, Leukobasischblau, Leukopararosanilin, Leukopatentblau A oder V.

Das Verhältnis von Farbbildner (a) und Photooxidationsmittel (b) in den photopolymerisierbare Aufzeichnungsmaterialien ist so zu wählen, daß auf alle Fälle ein hinreichender Farbumschlag bei Belichtung mit aktinischem Licht bewirkt wird. Üblicherweise hat es sich als sinnvoll herausgestellt, das photopolymerisierbare Photooxidationsmittel (b) in einem geringen Überschuß (gewichtsmäßig) im Vergleich zum Farbbildner (a) einzusetzen. Im übrigen werden Mengen und Mengenverhältnisse von Farbbildner (a) und Photooxidationsmittel (b) in der für den Fachmann üblichen und bekannten Weise so ausgewählt, daß die photopolymerisierbaren Aufzeichnungsmaterialien die an sie gestellten Anforderungen bezüglich Belichtungszeit, Farbkontrast etc. erfüllen.

Neben Sensibilisator und einem farbbildenden System der vorstehend beschriebenen Art enthalten die erfindungsgemäßen photopolymerisierbaren Aufzeichnungsmaterialien mindestens eine photopolymerisierbare, olefinisch ungesättigte organische Verbindung, gegebenenfalls ein polymeres Bindemittel, mindestens einen Photopolymerisationsinitiator sowie gegebenenfalls weitere Zusatz- und/oder Hilfsstoffe. Für diese weiteren Bestandteile der erfindungsgemäßen photopolymerisierbaren Aufzeichnungsmaterialien kommen die Verbindungen in Betracht, wie sie für die an sich bekannten photopolymerisierbaren Massen, die für die Herstellung von Überzügen, Druckplatten, Photoresistmaterialien, und ähnlichen Zwecken eingesetzt werden, verwendet werden und beispielsweise in der eingangs zitierten Literatur beschrieben sind.

Bei den photopolymerisierbaren, olefinisch ungesättigten organischen Verbindungen kann es sich um olefinisch ungesättigte Monomere, olefinisch ungesättigte Oligomere und/oder Polymere mit photopolymerisierbaren, olefinischen Doppelbindungen handeln. Die photopolymerisierbaren, olefinisch ungesättigten organischen Verbindungen enthalten vorzugsweise vinylische Doppelbindungen und insbesondere Vinyl-Gruppen, die durch Konjugation und/oder Nachbarschaftsstellung zu O- oder N-Atomen aktiviert sind. Hierzu gehören insbesondere die Vinyl-Gruppen in Nachbarschaft zu Ester- oder Amidgruppen, wie z.B. die Acryloyl- und Methacryloyl-Gruppierungen. Die photopolymerisierbaren, olefinisch ungesättigten organischen Verbindungen können sowohl mono- als auch polyfunktionell sein, d.h. sie können eine oder auch mehrere der photopolymerisierbaren olefinsichen Doppelbindungen besitzen. Üblicherweise sind in den photopolymerisierbaren Aufzeichungsmaterialien bi- oder mehrfunktionelle olefinisch ungesättigte, photopolymerisierbare Verbindungen allein oder Mischungen hiervon mit monofunktionellen olefinisch ungesättigten photopolymerisierbaren organischen Verbindungen enthalten. Die photopolymerisierbaren olefinisch ungesättigten Monomeren haben im allgemeinen ein Molekulargewicht von bis zu etwa 1 000. Das mittlere Molekulargewicht (Zahlenmittel) der photopolymerisierbaren olefinisch ungesättigten Oligomeren liegt vorzugsweise im Bereich von etwa 1 000 bis 10 000, insbesondere von etwa 1 500 bis 6 000. Das Molekulargewicht (Gewichtsmittel) der photopolymerisierbare olefinische Doppelbindungen enthaltenden Polymeren liegt im allgemeinen über 15 000. Die photopolymerisierbaren, olefinisch ungesättigten organischen Verbindungen können allein oder auch in Mischung miteinander eingesetzt werden. Art und Menge der verwendeten photopolymerisierbaren, olefinisch ungesättigten organischen Verbindungen richten sich weitgehend nach dem Anwendungszweck der photopolymerisierbaren Aufzeichnungsmaterialien sowie nach der Art der weiteren mitverwendeten Bestandteile.

Als Vertreter für die photopolymerisierbaren Monomeren seien insbesondere die Derivate der (Meth)acrylsäure und ganz besonders die (Meth)acrylsäureester genannt. Beispiele hierfür sind die Di- und Tri-(meth)acrylate von Ethylenglykol, Diethylenglykol, Triethylenglykol oder Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,6-Butandiol, 1,1,1-Trimethylolpropan, 2,2-Dimethylpropandiol, Glycerin, oder Pentaerythrit; Pentaerythrittetra-(meth)acrylat, Glukosetri- oder tetra-(meth)acrylat; ferner die Monoacrylate und Monomethacrylate der genannten Diole und Polyole, wie z.B. Ethylenglykol-, Di-, Tri- oder Tetraethylenglykol-mono-(meth)acrylat, Propandiolmono-(meth)acrylat und Butandiol-mono-(meth)acrylat; sowie die (Meth)-acrylate von Monoalkanolen, insbesondere von solchen mit 1 bis 20 C-Atomen. Neben den bevorzugten Acrylaten und Methacrylaten der vorstehend genannten Art seien als photopolymerisierbare Monomere auch die Allyl-Verbindungen und andere Vinyl-Verbindungen genannt, wie z.B. N-Vinylpyrrolidon, N-Vinylcarbazol, N-Vinylcaprolactam, Vinylacetat, Vinylpropionat, (Meth)acrylamid, N-Methylol-(meth)acrylamid, der Bisether des Ethylenglykols und N-Methylol-(meth)acrylamids, Vinylcarbamate, Bisacrylamidoessigsäure, Glyoxalbisamid u.a.

Sehr geeignete photopolymerisierbare, olefinisch ungesättigte organische Verbindungen für die erfindungsgemäßen, photopolymerisierbaren Aufzeichnungsmaterialien sind auch die monomeren Urethanacrylate bzw. -methacrylate mit zwei oder mehr Acryloyl- und/oder Methacryloyl-Gruppen. Solche monomeren Urethan-(meth)acrylate können beispielsweise erhalten werden durch die Umsetzung von aliphatischen Di- oder Polyolen mit organischen Diisocyanaten in einem Äquivalentverhältnis OH:NCO von etwa 1:2 und anschließende Umsetzung der freien Isocyanatgruppen des erhaltenen Reaktionsprouktes mit geeigneten Acryloyl- und/oder Methacryloyl-Verbindungen, beispielsweise Hydroxyalkyl-(meth)acrylaten. Als aliphatische Di- und/oder Polyole kommen u.a. die vorstehend im Zusammenhang mit den Di- und Tri-(meth)acrylaten genannten Di- und Polyhydroxy-Verbindungen in Betracht; als Beispiele für organische Diisocyanate seien Hexamethylendiisocyanat, Toluylendiisocyanat, Isophorondiisocyanat und ähnliche genannt: Hydroxyalkyl(meth)acrylate sind beispielsweise Hydroxylethyl(meth)acrylat, Propandiol-mono-(meth)acrylat oder Butandiol-mono-(meth)acrylat. Ebenso geeignet und vorteilhaft sind Monomere mit zwei oder mehr Acryloyl- und/oder Methacryloyl-Gruppen, wie sie beispielsweise erhalten werden können durch Umsetzung von Di- oder Polyglycidylverbindungen mit Acrylsäure und/oder Methacrylsäure bzw. durch Umsetzung von Glycidyl(meth)acrylat mit Di- oder Polyolen, insbesondere aliphatischen Di- oder Polyolen, wie sie beispielsweise vorstehend im Zusammenhang mit den Di- und Tri(meth)acrylaten genannt sind. Als Di- und Polyglycidylverbindungen kommen hier insbesondere die Di- und Polyglycidylether mehrwertiger aliphatischer Alkohole oder mehrwertiger Phenole, beispielsweise des Bisphenols A oder der Substitutionsprodukte von Bisphenol A in Betracht. Beispielhaft für solche Acryloyl- und/oder Methacryloyl-Gruppen enthaltenden Monomeren seien die Umsetzungsprodukte des Bisphenol A-bisglycidylethers mit Acryl- und/oder Methacrylsäure im molaren Verhältnis von etwa 1:2 sowie das 1,6-Hexandiol-bis-glycidylether-methacrylat genannt.

Als vorteilhaft, insbesondere für die Herstellung von Photoresistschichten, hat es sich erwiesen, wenn die photopolymerisierbaren Aufzeichungsmaterialien als photopolymerisierbare, olefinisch ungesättigte organische Verbindung Oligomere mit zwei oder vorzugsweise mehr als zwei Acryloyl- und/oder Methacryloyl-Gruppen enthalten. Hierbei kann es sich beispielsweise um Acryloyl- und/oder Methacryloyl-Gruppen enthaltende oligomere Urethan-Harze oder um solche auf Basis von Di- oder Polyepoxiden handeln, wie sie als solche bekannt und in der Literatur beschrieben sind. Für wäßrig entwickelbare photopolymerisierbare Aufzeichnungsmaterialien sind hierbei solche Oligomere der in Rede stehenden Art von besonderem Interesse, die neben den Acryloyl- und/oder Methacryloyl-Gruppen zusätzlich noch freie Carboxylgruppen im Molekül enthalten. Der Anteil der freien Carboxylgruppen in diesen photopolymerisierbaren Oligomeren liegt dabei vorteilhafterweise so hoch, daß die Oligomeren eine Säurezahl im Bereich von 50 bis 150 mg KOH/g aufweisen. Geeignete photopolymerisierbare Oligomere dieser Art sind z.B. in der DE-A-24 42 527, der DE-C-25 57 408 oder auch der DE-A-29 17 483 beschrieben. Weitere photopolymerisierbare Oligomere, deren Einsatz in den erfindungsgemäßen photopolymerisierbaren Aufzeichnungsmaterialien sich als vorteilhaft herausgestellt hat, können beispielsweise hergestellt werden, indem man die freien Hydroxylgruppen einer Acryloyl- und/oder Methacryloyl-Gruppen enthaltenden Diol- oder Polyolverbindung derart mit mehrfachen Carbonsäuren oder deren Derivaten, insbesondere cyclischen Carbonsäureanhydriden, umsetzt, daß sich die sauren Teilester der mehrfachen Carbonsäuren bilden, und anschließend einen Teil der freien Carboxylgruppen des so erhaltenen Reaktionsproduktes unter Kettenverlängerung sowie gegebenenfalls Verzweigung mit Di- und/oder Polyepoxiden umsetzt. Die Acryloyl- und/oder Methacryloyl-Gruppen enthaltenen Diol- oder Polyol-Verbindungen, die als Ausgangsprodukt für die Herstellung solcher Oligomeren dienen, werden zweckmäßigerweise hergestellt, indem man Di- oder Polyepxoid-Verbindungen, wie zu.B. Di-oder Polyglycidylether bzw. Di- oder Polyglycidylester, mit Acrylsäure und/oder Methacrylsäure im Äquivalentverhältnis Glycidyl-Gruppen:COOH-Gruppen von etwa 1:1 umsetzt. Die Di- oder Polyepoxid-Verbindungen können dabei auch beispielsweise vor oder während der Umsetzung mit der (Meth)acrylsäure durch Umsetzung mit Dicarbonsäuren vorverlängert werden. Beispielhaft und stellvertretend für solche Oligomeren der letztgenannten Art seien die Produkte genannt, wie sie erhältlich sind durch Umsetzung von Bisphenol-A-bisglycidylether mit Acryl- und/oder Methacrylsäure bzw. einem Gemisch aus etwa 30 bis 70 Mol.% einer Dicarbonsäure, beispielsweise Adipinsäure, und etwa 30 bis 70 Mol.% Acryl- und/oder Methacrylsäure im Äquivalentverhältnis Glycidyl-Gruppen:Gesamt-COOH von 1:1, Umsetzung der Hydroxyl-Gruppen des so erhaltenen Reaktionsproduktes mit einem cyclischen Dicarbonsäureanhydrid, beispielsweise Phthalsäureanhydrdid, gegebenenfalls in Mischung mit einem untergeordneten Anteil des Anhydrids einer anderen mehrfachen Carbonsäure, z.B. Trimellithsäureanhydrid, im Äquivalentverhältnis OH-Gruppen:Anhydrid-Gruppen von 1:1 unter Bildung der sauren Teilester der mehrfachen Carbonsäuren und schließlich Umsetzung eines Teils der freien Carboxyl-Gruppen des so erhaltenen Reaktionsproduktes mit einem Di-und/oder Polyglycidylether, beispielsweise Bisphenol-A-bisglycidylether oder Pentaerythrittriglycidylether, im Äquivalentverhältnis COOH-Gruppen:Glycidylgruppen von >1:1, vorzugsweise im Bereich von etwa 1,15:1 bis 5:1.

Als photopolymerisierbare olefinische Doppelbindungen enthaltene Polymere kommen beispielsweise solche lichtempfindliche Polymere in Betracht, wie sie z.B. in der DE-A-15 22 359 beschrieben sind.

Die photopolymerisierbaren, olefinisch ungesättigten organischen Verbindungen, die üblicherweise einen Siedepunkt von über 100°C bei Atmosphärendruck aufweisen, sind dabei - für den Fachmann selbstverständlich - so zu wählen, daß sie mit den übrigen Bestandteilen der photopolymerisierbare Aufzeichnungsmaterialien, insbesondere gegebenenfalls mitverwendeten polymeren Bindemitteln, verträglich sind.

Die bevorzugten photopolymerisierbaren Aufzeichnungsmaterialien enthalten neben den photopolymerisierbaren, olefinisch ungesättigten organischen Verbindungen polymere Bindemittel, insbesondere dann, wenn als photopolymerisierbare, olefinisch ungesättigte organische Verbindungen ausschließlich photopolymerisierbare Monomere und/oder photopolymerisierbare Oligomere enthalten sind. Die polymeren Bindemittel sollen dabei in den Entwicklerlösungsmitteln für die photopolymerisierbare Aufzeichnungsmaterialien löslich oder zumindest dispergierbar sein, um ein Auswaschen der unbelichteten und unvernetzten Anteile einer Schicht aus diesen Materialien nach einer bildmäßigen Belichtung mit aktinischem Licht zu ermöglichen. Als geeignte polymere Bindemittel seien genannt: lineare Polyamide und besonders alkohollösliche Copolyamide, wie sie in der FR-PS 1 520 856 beschrieben sind. Cellulosederivate, insbesondere wäßrig-alkalisch auswaschbare Cellulosederivate, Vinylalkohol-Polymere und Polymere und Copolymere von Vinylestern aliphatischer Monocarbonsäuren mit 1 bis 4 C-Atomen, wie von

Vinylacetat, mit unterschiedlichem Verseifungsgrad, Homo- und Copolymerisate des Vinylpyrrolidons, des Vinylchlorids oder des Styrols, Polyurethane, Polyetherurethane, Polyesterurethane, Polyesterharze, Dien-Polymere und -Copolymere, wie Blockcopolymerisate aus Butadien und/oder Isopren und Styrol oder α-Methylstyrol, sowie, insbesondere für die Herstellung von Photoresistschichten und Flachdruckplatten, auch die Acrylsäurealkylester- und Methacrylsäurealkylester-Polymerisate und -Copolymerisate. Beispiele für geeignte und bevorzugte polymere Bindemittel sind u.a. Polymethacrylat, Polymethylmethacrylat, Alkyl-(meth)acrylat-Copolymerisate, die Amino-Gruppen enthaltende Comonomere, wie z.B. Dimethylaminoethylmethacrylat, einpolymerisiert enthalten, Copolymerisate von Alkyl(meth)acrylaten und (Meth)acrylsäure, die gegebenenfalls noch weitere Comonomere, wie z.B. N-Vinyllactame, Hydroxyalkyl(meth)acrylate oder Styrol, einpolymerisiert enthalten, Copolymerisate aus Styrol und Maleinsäureanhydrid und/oder Maleinsäurehalbester oder auch Copolymerisate von Styrol, Maleinsäureanhydrid und (Meth)acrylsäure.

Die erfindungsgemäßen photopolymerisierbaren Aufzeichnungsmaterialien enthalten ferner - zusätzlich zu dem Photooxidationsmittel (b) des farbbildenden Systems - als weitere lichtempfindliche Komponente mindestens einen Photopolymerisationsinitiator, der unter Einwirkung von aktinischem Licht die radikalische Polymerisation der photopolymerisierbaren, olefinisch ungesättigten organischen Verbindungen in den photopolymerisierbaren Aufzeichnungsmaterialien zu initiieren vermag. Als besonders vorteilhaft haben sich hier die als Photoinitiatoren bekannten aromatischen Carbonylverbindungen erwiesen, insbesondere aromatische Ketone, die eine Struktureinheit der allgemeinen Formel (XXII)

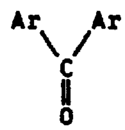

(XXII)

aufweisen, worin Ar für einen gegebenenfalls substituierten Arylrest, insbesondere einen gegebenenfalls substituierten Phenylrest, steht. Die beiden Reste Ar in der Struktureinheit der allgemeinen Formel (XXII) können dabei gleich oder verschieden sein sowie gegebenenfalls auch, beispielsweise über eine -CH-Gruppe oder ein -S-Atom, miteinander verknüpft sein. Bevorzugt werden die Photopolymerisationsinitiatoren so ausgewählt, daß sie keine starke Absorption (ε >5000) in dem Wellenlängenbereich des aktinischem Lichts haben, in dem die in den erfindungsgemäßen photopolymerisierbaren Aufzeichnungsmaterialien enthaltenen Sensibilisatoren ihre Absorptionsbande(n) haben. Als Beispiele für bevorzugte Photopolymerisationsinitiatoren seien genannt: Benzophenon, substituierte Benzophenone, wie 4,4'-Dichlorbenzophenon, Benzoinether, Benzildialkylketale, mehrkernige unsubstituierte Chinone, wie Anthrachinon, Benzanthrachinon, 2-Ethylanthrachinon oder tert.-Butylanthrachinon, Thioxanthon und seine Derivate, wie z.B. 2-Methylthioxanthon und 2-Chlorthioxanthon. Neben den genannten Bestandteilen können die erfindungsgemäßen photopolymerisierbaren Aufzeichnungsmaterialien noch weitere, übliche, die verarbeitungs- und/oder anwendungstechnischen Eigenschaften der Aufzeichungsmaterialien verbessernde und/oder modifizierende Zusatz-und/oder Hilfsstoffe enthalten. Hierzu gehören u.a. Inhibitoren der thermischen Polymerisation, anorganische oder organische Pigmente oder Farbstoffe, die sowohl als Kontrastmittel als auch schichtverfestigend wirken könen, niedermolekulare Haftvermittler, Verlaufshilfsmittel, Mattierungs- oder Gleitmittel, Weichmacher und dgl.

Die Bestandteile der erfindungsgemäßen photopolymerisierbaren Aufzeichnungsmaterialien werden in den für sie üblichen und an sich bekannten Mengen und Mengenverhältnissen eingesetzt und liegen in den Aufzeichnungsmaterialien in homogener Mischung vor. Zur Herstellung der photopolymerisierbaren Aufzeichnungsmaterialien werden die Bestandteile nach den an sich bekannten Verfahren homogen miteinander vermischt, beispielsweise in Lösung in einem geeigneten Lösungsmittel oder Lösungsmittelgemisch oder in einer Mischvorrichtung, wie einem Kneter, Extruder oder dgl. Vorzugsweise werden Art und Menge der einzelnen Bestandteile der erfindungsgemäßen photopolymerisierbaren Aufzeichnungsmaterialien so aufeinander abgestimmt, daß die resultierende Mischung - sofern die Mischung in Lösung hergestellt wurde, nach Entfernung des Lösungsmittels - fest ist.

Zum Auslösen der Photopolymerisation und der Farbbildung bzw. der Vertiefung der Farbintensität in den erfindungsgemäßen photopolymerisierbaren Aufzeichnungsmaterialien dient aktinisches Licht einer Wellenlänge von 300 bis 420 nm, insbesondere solches im Wellenlängenreich von 320 bis 400 nm. Als Strahlungsquellen sind u.a. Quecksilberhochdrucklampen, Quecksilbermitteldrucklampen, Quecksilberniederdrucklampen, superaktinische Leuchtstoffröhren, Xenon-Impulslampen, UV-Fluoreszenzröhren und dgl. geeignet.

Die erfindungsgemäßen Aufzeichungsmaterialien können in an sich bekannter Weise zu UV-härtbaren Überzügen, Photopolymerdruckplatten jeder Art, Reliefformen, Photoresists und dgl. verarbeitet werden. Besonders vorteilhaft sind sie dort, wo bei der Bestrahlung mit aktinischem Licht neben einer guten Photopolymerisation in den belichteten Bereichen auch eine möglichst große Änderung der Farbintensität und ein möglichst großer Farbkontrast gewünscht wird, wie beispielsweise in lichtempfindlichen Aufzeichungselementen mit einer auf einem Trägermaterial aufgebrachten dünnen Schicht aus den erfindungsgemäßen photopolymerisierbaren Aufzeichnungsmaterialien, insbesondere Trockenfilmresists für die trockene Schichtübertragung und Flachdruckplatten. Als Trägermaterial für diese lichtempfindlichen Aufzeichungselemente kommen die hierfür üblichen dimensionsstabilen, vorzugsweise biegsamen, Materialien, wie Kunststoffilme oder -folien und Metallbleche, in Betracht. Für Trockenfilmresists haben sich als Träger insbesondere Polyesterfolien, beispielsweise aus Polyethylenterephthalat oder Polybutylenterephthalat, bewährt. Für Flachdruckplatten finden als Trägermaterialien insbesondere die offsettypischen Aluminiumbleche Anwendung, deren Oberfläche in an sich bekannter Weise mechanisch, chemisch und/oder elektrochemisch aufgerauht und vorbehandelt ist. Die dünne Schicht aus den erfindungsgemäßen photopolymerisierbaren Aufzeichnungsmaterialien, die für die Trockenfilmresists üblicherweise im Bereich von etwa 10 bis 100 µm, insbesondere im Bereich von etwa 1 bis 6 µm liegt, wird auf die Trägermaterialien nach bekannten Auftragstechniken, beispielsweise durch Gießen aus Lösung, spin coating oder dgl., aufgebracht.

Für die Herstellung von Flachdruckformen werden die mit den erfindungsgemäßen photopolymerisierbaren Aufzeichnungsmaterialien hergestellten Flachdruckplatten in üblicher Weise bildmäßig mit aktinischem Licht belichtet und durch Auswaschen mit einem geeigneten Entwicklerlösungsmittel entwickelt. Zur Herstellung von bildmäßig strukturierten Resistmustern wird das erfindungsgemäße photopolymerisierbare Aufzeichnungsmaterial schichtförmig auf das zu schützende, sowie gegebenenfalls dauerhaft zu modifizierende Substrat, entweder direkt, beispielsweise aus Lösung, oder durch Auflaminieren einer vorgefertigten Schicht nach dem Schichtübertragungsverfahren mittels eines Trockenfilmresist, aufgebracht. Als Substrat, dessen Art sich bekanntermaßen nach dem jeweiligen Anwendungszweck des herzustellenden Resistmusters richtet, kommen die in diesem Bereich üblichen und bekannten Materialien, wie z.B. Kupferbleche oder kupferkaschierte Basismaterialien, in Betracht. Zur Erzeugung des bildmäßig strukturierten Resistmusters wird die auf das Substrat aufgebrachte Photoresistschicht aus den erfindungsgemäße photopolymerisierbaren Aufzeichnungsmaterialien bildmäßig mit aktinischem Licht belichtet und anschließend unter Entfernen der unbelichteten Schichtbereiche mit einem geeigneten Entwicklerlösungsmittel ausgewaschen. Für die bildmäßige Belichtung der erfindungsgemäßen photopolymerisierbaren Aufzeichnungsmaterialien kommt aktinisches Licht in dem vorstehend genannten Wellenlängenbereich in Betracht. Die Art des Entwicklerlösungsmittel richtet sich nach den für den Aufbau der erfindungsgemäßen photopolymerisierbaren Aufzeichnungsmaterialien verwendeten Bestandteile, insbesondere dem eingesetzten polymeren Bindemittel und/oder den photopolymerisierbaren, olefinisch ungesättigten organischen Verbindungen. Danach können sowohl organische Lösungsmittel oder Lösungsmittelgemische wie auch wäßrige Entwicklerlösungen zur Anwendung kommen.

Das farbbildende System in den erfindungsgemäßen photopolymerisierbaren Aufzeichnungsmaterialien besitzt eine hohe Stabilität. Die photopolymerisierbaren Aufzeichnungsmaterialien weisen daher eine ausgezeichnete Dunkellagerfähigkeit auf, ohne daß es hierzu des Zusatzes großer Mengen eines Inhibitors der thermischen Polymerisation bedarf, wie er bei den Produkten nach dem Stand der Technik erforderlich ist. Bei der Belichtung mit aktinischem Licht zeigen die erfindungsgemäßen photopolymerisierbaren Aufzeichnungsmaterialien eine unerwartet große Zunahme der Farbintensität und einen stärkeren Farbkontrast zwischen belichteten und unbelichteten Bereichen, als er bei vergleichbaren bekannten Produkten erzielt wird, die als Photooxidationsmittel eine organische Halogenverbindung enthalten. Dies war völlig überraschend, zumal die aus dem Stand der Technik bekannten photographischen Aufzeichnungsmaterialien mit einem ähnlichen farbbildenden System, die aber, im Vergleich zu den erfindungsgemäßen photopolymerisierbaren Aufzeichnungsmaterialien keine photopolymerisierbaren, organischen Verbindungen, Photoinitiatoren und Sensibilisatoren enthalten, bei vergleichbaren Belichtungszeiten nur eine relativ schwache Farbänderung zeigen. Die Verwendung der Photooxidationsmittel in den erfindungsgemäßen photopolymerisierbaren Aufzeichnungsmaterialien hat dabei keinen nachteiligen Einfluß auf die anderen, für die Herstellung und Verwendung dieser Aufzeichnungsmaterialien wichtigen anwendungstechnischen Eigenschaften. Im Gegenteil besitzen die erfindungsgemäßen Materialien vielfach sogar etwas bessere Belichtungseigenschaften. Ebenfalls von Vorteil, besonders für deren Einsatz in Photoresistmaterialien, ist das schwache Fluoreszenzverhalten der erfindungsgemäßen Sensibilisatoren, wodurch auf den Zusatz weiterer Stoffe zur Absorption derartiger Streustrahlung verzichtet werden kann und die Herstellung auch feinerer Leiterbahnstrukturen möglich ist. Darüber hinaus wird mit den erfindungsgemäßen photopolymerisierbaren Aufzeichnungsmaterialien überraschenderweise auch das Restschicht-Problem überwunden, d.h. die aus den erfindungsgemäßen photopolymerisierbaren Aufzeichnungsmaterialien hergestellten, bildmäßig belichteten und entwickelten Schichten lassen sich von dem Substrat auch nach längerer Zeit wieder vollständig und ohne Rückstand durch Strippen mit einem Lösungsmittel entfernen. Dies ist insbesondere für die Verwendung als Photoresist, z.B. bei der Herstellung von Leiterplatten und integrierten Schaltungen, von großer Bedeutung.

Die Erfindung wird durch die nachfolgenden Beispiele näher erläutert. Die in den Beispielen und Vergleichsversuchen genannten Teile und Prozente beziehen sich, sofern nicht anders angegeben, auf das Gewicht.

Beispiel 1

Es wurde eine homogene Mischung aus folgenden Bestandteilen hergestellt: 250 TeileEssigsester,

16 TeileTrimethylolpropantriacrylat,
18 Teiledes äquimolaren Umsetzungsproduktes von Bisphenol-A-bis-glycidylether mit Acrylsäure
54 TeilePolymethylmethacrylat mit einem mittleren Molekulargewicht (Gewichtsmittel) von 153 000,
3,0 TeileBenzophenon,
0,15 TeileChinazolon-4 der Formel (V)
0,8 TeileKristallviolett-Leukobase,
2,0 TeileN-Methoxy-2-picolinium-tosylat,
0,05 TeileSicomet-Patentblau
6,0 TeileTriethylenglykoldiacetat.

Diese Lösung wurde zunächst so auf eine Polyester-Folie gegossen, daß nach dem Ablüften des Lösungsmittels und Trocknen eine Trockenschichtdicke von 35 µm resultierte. Die Extinktion (600 nm) der Schicht betrug 0,12. Für die Herstellung eines Resistmusters wurde die photopolymerisierbare Resistschicht bei 110°C auf ein kupferkaschiertes Leiterplattensubstrat auflaminiert, durch ein photographisches Negativ 30 Sekunden in einem Flachbelichter mit aktinischem Licht einer Wellenlänge von 360 nm belichtet; anschließend wurden nach Entfernung der Polyesterfolie die unbelichteten Schichtanteile mit 1,1,1-Trichlorethan ausgewaschen. Durch die Belichtung wurde eine starke Vertiefung der Farbintensität in der Schicht bewirkt, wobei sich die Extinktion der Schicht bei 600 nm um 0,64 auf 0,76 änderte. Das erzeugte Resistmuster konnte auch nach 3-tägiger Lagerung anstandslos und ohne Verbleiben eines Restbelages mit Methylenchlorid von dem Substrat gestrippt werden.

Vergleichsversuch A

Es wurde wie in Beispiel 1 gearbeitet, jedoch wurden diesmal bei der Herstellung der Mischung anstelle der 2 Teile des N-Methoxy-2-picoliniumtosylats diesmal 3 Teile 2,5-Dichlor-1,4-bis-(dichlormethyl)-benzol eingesetzt; gleichzeitig wurde der Anteil des Triethylenglykoldiacetats von 5,94 Teilen auf 4,94 Teile reduziert. Bei gleicher Extinktion (600 nm) der unbelichteten Resistschicht wurde diesmal durch die Belichtung lediglich eine Extinktionszunahme von 0,2 gemessen. Der Farbkontrast zwischen belichteten und unbelichteten Bereichen war deutlich schwächer.

Beispiel 2

Es wurde eine homogene Mischung aus folgenden Bestandteile hergestellt: 250 TeileEssigester,
18,5 TeileTrimethylolpropantriacrylat,
16,5 Teiledes äquimolaren Umsetzungsproduktes von Bisphenol-A-bis-glycidylether mit Acrylsäure
56 TeilePolymethylmethacrylat/Acrylsäure-Copolymer
0,5 TeileLeukokristallviolett,
1,9 Teile2,2′-Bis(o-chlorphenyl)-4,4′, 5,5′-tetraphenylbisimidazolyl
0,3 TeileChinazolon der Formel (III)
0,05 TeileFlexoblau
6,5 TeileTriethylenglykoldiacetat.

Wie in Beispiel 1 beschrieben, wurde eine Schicht mit einer Dicke von 35 µm hergestellt und auf ein kupferkaschiertes Leiterplattensubstrat aufgebracht.

Nach Belichtung gemäß Beispiel 1 wird eine starke Vertiefung der Farbintensität beobachtet, wobei sich die Extinktion der Schicht um 0,5 auf 0,82 bei einer Wellenlänge von 600 nm erhöht.

Vergleichsversuch B

Es wurde wie in Beispiel 2 gearbeitet, jedoch wurden diesmal bei der Herstellung der Mischung anstelle des Chinazolons der Formel (III) die äquivalente Menge an Michlers Keton eingesetzt. Nach Belichtung gemäß Beispiel 2 wurde eine Extinktion von 0,69 bei gleicher Extinktion der unbelichteten Resistschicht gemessen.

Beispiel 3 bis 11

Es wurde gemäß Beispiel 2 gearbeitet. Folgende Extinktionswerde OD wurden gemessen.

| Beispiel | Sensibilisator der Formel | Photooxidans | OD |
|---|---|---|---|
| 3 | (II) | A | 0,73 |
| 4 | (IV) | B | 0,69 |
| 5 | (VI) | A | 0,76 |
| 6 | (VII) | A | 0,88 |
| 7 | (VIII) | A | 0,86 |
| 8 | (VIII) | B | 0,95 |
| 9 | (X) | A | 0,85 |
| 10 | (X) | B | 0,93 |
| 11 | (IX) | A | 0,86 |

A = 2,2'-Bis(o-chlorphenyl)-4,4',5,5'-tetraphenylbisimidazolyl
B = N-Methoxy-2-picoliniumtosylat

Beispiel 12

Herstellung des Sensibilisators der Formel (V)

0,1 mol p-Diethylaminobenzoesäure, 0,1 mol Anthranilsäure, 0,1 mol Triphenylphosphit und 200 ml Pyridin wurden 4 Stunden auf 100°C erhitzt. Anschließend setzt man 0,1 mol Anilin zu und erhitzt weitere 3 Stunden auf 100°C. Pyridin wird abdestilliert, der Rückstand mit 10 %iger Natronlauge sowie verdünnter Salzsäure gewaschen und anschließend aus Toluol umkristallisiert.
Ausbeute: 98 %Schmp.: 165-169°C

Beispiel 13

Die folgenden Sensibilisatoren wurden in Analogie zu dem in Beispiel 12 beschriebenen Verfahren hergestellt. Die Schmelzpunkte der erhaltenen Verbindungen sind nachstehend aufgeführt.

| Sensibilisator der Formel | Schmp. |
|---|---|
| (VIII) | 158-162°C |
| (IX) | 200°C |
| (X) | 258°C |

**Patentansprüche**

1. Photopolymerisierbare Aufzeichnungsmaterialien mit mindestens einer photopolymerisierbaren, olefinisch ungesättigten organischen Verbindung, gegebenenfalls einem polymeren Bindemittel, mindestens einem Photopolymerisationsinitiator, einem farbbildenden System, welches bei Bestrahlung mit aktinischem Licht eine Zunahme der Farbintensität der Aufzeichnungsmaterialien bewirkt, einem Sensibilisator sowie gegebenenfalls weiteren Zusatz- und/oder Hilfsstoffen, dadurch gekennzeichnet, daß sie als Sensibilisatoren wenigstens eine Verbindung der allgemeinen Formel (I)

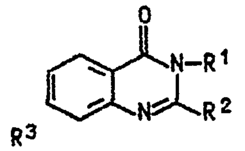

(I)

enthalten, in der

$R^1$ für $C_1$- bis $C_{12}$-Alkyl, Cycloalkyl, Phenyl, durch Halogen, $C_1$- bis $C_{12}$-Alkyl, Nitril, Trifluormethyl, $C_1$- bis $C_{12}$-Alkoxy, -O-CO-$C_1$- bis -$C_{12}$-Alkyl, -CO-O-$C_1$- bis - $C_{12}$-Alkyl oder $NR^4R^5$ substituiertes Aryl oder Heteroaryl steht, wobei $R^4$ und $R^5$ untereinander gleich oder verschieden sind und für $C_1$- bis $C_8$-Alkyl, Aryl-$C_1$- bis -$C_6$-alkyl, wobei der Arylrest durch Halogen, $C_1$- bis $C_6$-Alkyl oder $C_1$- bis $C_6$-Alkoxy ein- oder mehrfach substituiert sein kann, für gegebenenfalls durch $C_1$- bis $C_6$-Alkyl, $C_1$- bis $C_6$-Alkoxy, Nitril, Trifluormethyl und/oder Halogen ein- oder mehrfach substituiertes Phenyl, für gegebenenfalls durch OH, Halogen, CN, -O-CO-$C_1$- bis -$C_6$-Alkyl oder -CO-O-$C_1$- bis -$C_6$-alkylsubstituiertes $C_1$- bis $C_{12}$-Alkyl oder Oxaalkyl mit 3 bis 12 Kohlenstoffatomen und 1 bis 5 Sauerstoffatomen stehen oder $R^4$ und $R^5$ zusammen ein gesättigtes oder ungesättigtes heterocyclisches Ringsystem bilden;

$R^2$ für $C_1$- bis $C_{12}$-Alkyl, Cycloalkyl, Phen-$C_1$- bis -$C_6$-alkyl, für Aryl oder Heteroaryl oder für durch $C_1$- bis $C_{12}$-Alkyl, das durch OH, Halogen, CN, -O-CO-$C_1$- bis -$C_6$-Alkyl oder -CO-O-$C_1$- bis -$C_6$-Alkyl substituiert sein kann, $C_1$- bis $C_6$-Alkoxy, OH, Halogen, CN oder -O-CO-$C_1$- bis -$C_6$-Alkyl, -CO-O-$C_1$- bis -$C_6$-Alkyl, Oxaalkyl mit 2 bis 12 Kohlenstoffatomen und 1 bis 6 Sauerstoff- atomen oder durch $NR^6R^7$ substituiertes Aryl oder Heteroaryl steht, wobei $R^6$ und $R^7$ untereinander gleich oder verschieden sind und für $C_1$- bis $C_8$-Alkyl, Allyl, Aryl-$C_1$- bis -$C_6$-alkyl, wobei der Arylrest durch Halogen, $C_1$-bis $C_6$-Alkyl oder $C_1$- bis $C_6$-Alkoxy ein- oder mehrfach substituiert sein kann, für Phenyl oder durch $C_1$-bis -$C_6$-Alkyl, $C_1$- bis -$C_6$-Alkoxy und/oder Halogen ein- oder mehrfach substituiertes Phenyl, für durch OH, Halogen, CN, -O-CO-$C_1$- bis -$C_6$-Alkyl oder -CO-O-$C_1$- bis -$C_6$-alkylsubstituiertes $C_1$- bis $C_{12}$-Alkyl oder Oxaalkyl mit 3 bis 12 Kohlenstofatomen und 1 bis 5 Sauerstoffatomen stehen oder $R^6$ und $R^7$ zusammen ein heterocyclisches gesättigtes oder ungesättigtes Ringsystem bilden und

$R^3$ für Wasserstoff, $C_1$- bis $C_{12}$-Alkyl, $C_1$- bis $C_{12}$-Alkoxy, durch OH, Halogen, CN, -O-CO-$C_1$- bis -$C_6$-Alkyl oder -CO-O-$C_1$- bis -$C_6$-Alkyl substituiertes $C_1$- bis $C_{12}$-Alkyl oder Oxaalkyl mit 2 bis 12 Kohlenstoffatomen und 1 bis 5 Sauerstoffatomen, Halogen, Trialkylsilyl oder Perfluor-$C_1$- bis $C_7$-alkyl steht,

mit der Maßgabe, daß das Maximum der langwelligen Absorptionsbande dieser Verbindungen unter 420 nm, vorzugsweise unter 400 nm liegt.

2. Photopolymerisierbare Aufzeichnungsmaterialien nach Anspruch 1, dadurch gekennzeichnet, daß sie als Sensibilisator mindestens eine Verbindung der Formel (I) enthalten, worin $R^1$ und $R^2$ gemäß Anspruch 1 definierte Arylreste und $R^3$ für Wasserstoff stehen.

3. Photopolymerisierbare Aufzeichnungsmaterialien nach Anspruch 1 oder 2, dadurch gekennzeichnet, daß sie als Sensibilisator mindestens eine Verbindung der allgemeinen Formel (I) enthalten, worin $R^1$ für einen gemäß Anspruch 1 substituierten Phenyl- oder Benzylrest, $R^2$ für einen durch $NR^6R^7$ substituierten Arylrest, wobei $R^6$ und $R^7$ die in Anspruch 1 genannte Bedeutung haben, stehen.

4. Photopolymerisierbare Aufzeichnungsmaterialien nach einem der Ansprüche 1 bis 3, dadurch gekennzeichnet, daß sie als farbbildendes System, welches bei Bestrahlung mit aktinischem Licht eine Zunahme der Farbintensität der Aufzeichnungsmaterialien bewirkt,

(a) mindestens eine farblose oder praktisch farblose organische Verbindung, die zu einer farbigen Verbindung oxidierbar ist, und

(b) ein Photooxidationsmittel für die farblose oder praktisch farblose organische Verbindung (a) enthalten.

5. Photopolymerisierbare Aufzeichnungsmaterialien nach Anspruch 4, dadurch gekennzeichnet, daß sie als Photopolymerisationsinitiator und/oder Photooxidationsmittel wenigstens ein Hexaarylbisimidazolyl enthalten.

6. Photopolymerisierbare Aufzeichnungsmaterialien nach Anspruch 4, dadurch gekennzeichnet, daß sie als Photooxidationsmittel (b) mindestens ein N-Alkoxypyridiniumsalz enthalten.

7. Photopolymerisierbare Aufzeichnungsmaterialien nach einem der Ansprüche 1 bis 6, dadurch gekennzeichnet, daß sie als farblose oder praktisch farblose organische Verbindung, die zu einer farbigen Verbindung oxidierbar ist, einen Leukofarbstoff, insbesondere einen Triarylmethanfarbstoff in seiner Leukoform enthalten.

8. Photoresistschichten auf Basis von photopolymerisierbaren Aufzeichnungsmaterialien nach einem der Ansprüche 1 bis 7.

9. Flachdruckplatten auf Basis von photopolymerisierbaren Aufzeichnungsmaterialien nach einem der Ansprüche 1 bis 7.

10. Chinazolon-4-verbindungen der allgemeinen Formel

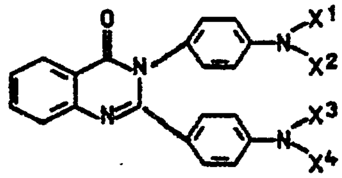

worin $X^1$, $X^2$, $X^3$ und $X^4$ untereinander gleich oder verschieden sind und für Kohlenwasserstoffreste mit 1 bis 12 Kohlenstoffatomen stehen, die durch OH, CN, Halogen, Phenyl, -O-CO-$C_1$- bis -$C_6$-Alkyl, -CO-O-$C_1$- bis -$C_6$-Alkyl oder Oxaalkyl mit 3 bis 12 Kohlenstoffatomen und 1 bis 5 Sauerstoffatome substituiert sein können.

11. Chinazolon-4-verbindungen nach Anspruch 10, dadurch gekennzeichnet, daß $X^1$ bis $X^4$ für Alkylreste mit 1 bis 4 Kohlenstoffatomen stehen.

12. Chinazolon-4-verbindungen nach einem der Ansprüche 10 oder 11, dadurch gekennzeichnet, daß die Reste $X^1$ bis $X^4$ für Methyl- oder Ethylgruppen stehen.

## Claims

1. A photopolymerizable recording material composed of one ore more photopolymerizable olefinically unsaturated organic coumpounds, optionally a polymeric binder, one or more photopolymerization initiators, a color-forming system which on irradiation with actinic light causes an increase in the color intensity of the recording material, a sensitizer and optionally further additive and/or auxiliary substances, wherein the sensitizer comprises one or more compounds of the formula (I)

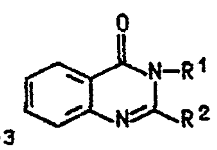

(I)

where $R^1$ is $C_1$- to $C_{12}$-alkyl, cycloalkyl, phenyl or halogen-, $C_1$- to $C_{12}$-alkyl, nitrile-, trifluoromethyl-, $C_1$- to $C_{12}$-alkoxy-, –O–CO–$C_1$- to -$C_{12}$-alkyl-, –CO–O–$C_1$- to -$C_{12}$-alkyl- or $NR^4R^5$-substituted aryl or hetaryl, where $R^4$ and $R^5$ are identical or different and each is $C_1$- to $C_8$-alkyl, aryl-$C_1$- to -$C_6$-alkyl, where the aryl can be monosubstituted or polysubstituted by halogen, $C_1$- to $C_6$-alkyl or $C_1$- to $C_6$-alkoxy, or each is unsubstituted or $C_1$- to $C_6$-alkyl-, $C_1$- to $C_6$-alkoxy-, nitrile-, trifluoromethyl- and/or halogen-monosubstituted or -polysubstituted phenyl, unsubstituted or OH–, halogen, CN–, –O–CO–$C_1$- to -$C_6$-alkyl- or –CO–O–$C_1$– to -$C_6$-alkyl- substituted $C_1$- to $C_{12}$-alkyl or oxaalkyl of 3 to 12 carbon atoms and 1 to 5 oxygen atoms, or $R^4$ and $R^5$ together from a saturated or unsatureted hetocyclic ring system, $R^2$ is $C_1$- to $C_{12}$-alkyl, cycloalkyl, phen-$C_1$- to -$C_6$-alkyl, aryl or hetaryl or $C_1$- to $C_{12}$-alkyl-, which may be substituted by OH, halogen, CN, –O–CO–$C_1$- to -$C_6$-alkyl or -CO–O–$C_1$- to -$C_6$-alkyl, $C_1$- to $C_6$-alkxy-, OH–, halogen-, CN– or d–O–CO–$C_1$- to -$C_6$-alkyl-,–CO–O–$C_1$– to -$C_6$-alkyl-, oxa alkyl- of 2 to 12 carbon atoms and 1 to 6 oxygen atoms or $NR^6R^7$-substituted aryl or hetaryl. where $R^6$ and $R^7$ are identical or different and each is $C_1$- to $C_8$-alkyl, allyl, aryl-$C_1$- to -$C_6$-alkyl, where the aryl can be monosubstituted or polysubstituted by halogen, $C_1$- to $C_6$-alkyl or $C_1$- to $C_6$-alkoxy, or each is phenyl which is unsubstituted or monosubstituted or polysubstituted by $C_1$- to $C_6$-alkyl, $C_1$- to $C_6$-alkoxy and/or halogen, or each is OH–, halogen-, CN–, –O–CO–$C_1$- to -$C_6$-alkyl- or –CO–O–$C_1$– to -$C_6$-alkyl- substituted $C_1$- to $C_{12}$-alkyl or pxaalkyl of 3 to 12 carbon atoms and 1 to 5 oxygen atoms, or $R^6$ and $R^7$ together form a saturated or unsaturated heterocyclic ring system, and $R^3$ is hydrogen, $C_1$- to $C_{12}$-alkyl, $C_1$- to $C_{12}$-alkoxy, OH-, halogen-, CN–, –O–CO–$C_1$- to -$C_6$-alkyl-, –CO–O–$C_1$- to -$C_6$-alkyl-substituted $C_1$- to $C_{12}$-alkyl or oxaalkyl of 2 to 12 carbon atoms and 1 to 5 oxygen atoms, halogen, trialkylsilyl or perfluoro-$C_1$- to -$C_7$-alkyl, with the proviso that the maximum of the long-wave absorption band of these compounds is below 420 nm, preferably below 400 nm.

2. A photopolymerizable recording material as claimed in claim 1, wherein the sensitizer comprises one or more compounds of the formula (I) where $R^1$ and $R^2$ are each aryl as defined in claim 1 and $R^3$ is hydrogen.

3. A photopolymerizable recording material as claimed in either of the claims 1 or 2, wherein the sensitizer comprises one or more compounds of the formula (I) where $R^1$ is phenyl or benzyl substituted as in claim 1, and $R^2$ is $NR^6R^7$-substituted aryl, $R^6$ and $R^7$ being as defined in claim 1.

4. A photoplymerizable recording material as claimed in any one of claims 1 to 3, wherein the color-forming system which on irradiation with actinic light causes an increase in the color intensity of the recording material comprises

(a) one or more colorless or virutally colorless organic compounds which are oxidizable to colored compounds, and

(b) a photooxidant for the colorless or virtually colorless organic compound(s) (a).

5. A photopolymerizable recording material as claimed in claim 4, wherein the photopolymerization initiator and/or photooxidant comprises one or more hexaarylbisimidazolyls.

6. A photopolymerizable recording material as claimed in claim 4, wherein the photooxidant (b) comprises one or more N-alkoxypyridinium salts.

7. A photopolymerizable recording material as claimed in any one of claims 1 to 6, wherein the colorless or virtually colorless organic compound which is oxidizable to a colored compound comprises a leuco dye, in particular a triarylmethane dye in its leuco form.

8. A photoresist layer based on a photopolymerizable recording material as claimed in any one of claims 1 to 7.

9. A lithographic printing plate based on a photopolymerizable recording material as claimed in any one of claims 1 to 7.

10. 4-quinazolone compound of the formula

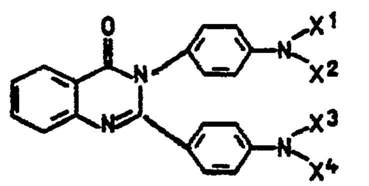

where $X^1$, $X^2$, $X^3$ and $X^4$ are identical to or different from each other and are each hydrocarbyl of 1 to 12 carbon atoms which may be substituted by OH, CN, halogen, phenyl, –O–CO–$C_1$- to -$C_6$-alkyl, –CO–O–$C_1$- to -$C_6$-alkyl or oxaalkyl of 3 to 12 carbon atoms and 1 to 5 oxygen atoms.

11. A 4-quinazolone compound as claimed in claim 10, wherein $X^1$ to $X^4$ are each of 1 to 4 carbon atoms.

12. A 4-quinazolone compound as claimed in either of claims 10 or 11, wherein $X^1$ to $X^4$ are each methyl or ethyl.

**Revendications**

1. Matériaux d'enregistrement photopolymérisables ayant au moins un composé organique insaturé oléfiniquement, photopolymérisable, éventuellement un liant polymère, au moins un initiateur de photopolymérisation, un système chromogène qui, par irradiation à la lumière actinique, provoque une augmentation d'intensité de couleur du matériau d'enregistrement, un sensibilisateur ainsi qu'éventuellement d'autres additifs et/ou auxiliaires, caractérisés par le fait qu'ils contiennent, comme sensibilisateurs, au moins un composé de la formule générale (I)

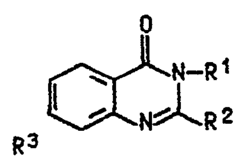

(I)

dans laquelle

$R^1$ est mis pour alkyle en $C_1$–$C_{12}$, cycloalkyle, phényle, aryle ou hétéroaryle substitué par halogène, alkyle en $C_1$–$C_{12}$, nitrile, trifluorométhyle, alcoxy en $C_1$–$C_{12}$, –O–CO-alkyle (en $C_1$–$C_{12}$), –CO–O-alkyle (en $C_1$–$C_{12}$) ou $NR^4R^5$, $R^4$ et $R^5$ étant identiques ou différents et sont mis pour alkyle en $C_1$–$C_6$, aryl-alkyle en $C_1$–$C_6$, le reste aryle pouvant être substitué, une ou plusieurs fois, par halogène, alkyle en $C_1$–$C_6$ ou alcoxy en $C_1$–$C_6$, pour phényle éventuellement subsitué, une ou plusieurs fois, par alkyle en $C_1$–$C_6$, alcoxy en $C_1$–$C_6$, nitrile trifluorométhyle et/ou halogène, phényle substitué une ou plusieurs fois, pour alkyle en $C_1$–$C_{12}$ ou oxaalkyle à 3 à 12 atomes de carbone et 1 à 5 atomes d'oxygène, éventuellement substitués par OH, halogène, CN, –O–CO-alkyle (en $C_1$–$C_6$) ou –CO–O-alkyle (en $C_1$–$C_6$), ou bien $R^4$ et $R^5$ forment ensemble un système hétérocyclique saturé ou insaturé;

$R^2$ est mis pour alkyle en $C_1$–$C_{12}$, cycloalkyle, phenalkyle en $C_1$–$C_6$, pour aryle ou hétéroaryle, ou pour aryle ou hétéroaryle substitués par alkyle en $C_1$–$C_{12}$, qui peut être substitué par OH, halogène, CN, –O–CO-alkyle en $C_1$–$C_6$ ou –CO–O-alkyle en $C_1$–$C_6$, alcoxy en $C_1$–$C_6$, OH, halogène, CN, ou –O–CO-alkyle en $C_1$–$C_6$ , –CO–O-alkyle en $C_1$–$C_6$, oxaalkyle à 2 à 12 atomes de carbone et 1 à 5 atomes d'oxygène, ou par $NR^6R^7$, $R^6$ et $R^7$ étant identiques ou différents et étant mis pour alkyle en $C_1$–$C_6$, allyle, arylalkyle en $C_1$–$C_6$, le reste aryle pouvant être substitué, une ou plusieurs fois, par halogène, alkyle en $C_1$–$C_6$, ou alcoxy en $C_1$–$C_6$, pour phényle ou phényle substitué, une ou plusieurs fois, par alkyle en $C_1$–$C_6$, alcoxy en $C_1$–$C_6$ et/ou halogène, pour alkyle en $C_1$–$C_{12}$ ou oxaalkyle à 3 à 12 atomes de carbone et 1 à 5 atomes d'oxygène, substitués par OH, halogène, CN, –O–CO-alkyle (en $C_1$–$C_6$) ou CO–O-alkyle (en $C_1$–$C_6$), ou bien $R^6$ et $R^7$ forment ensemble un système hétérocyclique saturé ou non

saturé, et

$R^3$ est mis pour hydrogène, alkyle en $C_1$–$C_{12}$, alcoxy en $C_1$–$C_{12}$, alkyle en $C_1$–$C_{12}$ ou oxaalkyle à 2 à 12 atomes de carbone et 1 à 5 atomes d'oxygène, substitués par OH, halogène, CN, –O–CO-alkyle (en $C_1$–$C_6$) ou –CO–O-alkyle (en $C_1$–$C_6$), halogène, trialkylsilyle ou perfluoro-alkyle (en $C_1$–$C_7$),

sous réserve que le maximum de la bande d'absorption les grandes longueurs d'onde ces composés soit inférieur à 420 nm, de préférence inférieur à 400 nm.

2. Matériaux d'enregistrement photopolymérisables selon la revendication 1, caractérisés par le fait qu'ils contiennent, comme sensibilisateurs au moins un composé de formule (I), dans laquelle $R^1$ et $R^2$ représentent des restes aryle définis selon la revendication 1 et $R^3$ est mis pour hydrogène.

3. Matériaux d'enregistrement photopolymérisables selon la revendication 1 ou 2, caractérisés par le fait qu'ils contiennent, comme sensibilisateurs, au moins un composé de formule (I), dans laquelle $R^1$ représente un reste phényle ou benzyle substitué selon la revendication 1, $R^2$ représente un reste aryle substitué par $NR^6R^7$, $R^6$ et $R^7$ ayant les significations données dans la revendication 1.

4. Matériaux d'enregistrement photopolymérisables selon l'une des revendications 1 à 3, caractérisés par le fait qu'ils contiennent, comme système chromogène colorant qui, par irradiation à la lumière actinique, provoque une augmentation d'intensité de couleur du matériau d'enregistrement:

(a) au moins un composé organique incolore ou pratiquement incolore, qui est oxydable en un composé coloré et

(b) un agent de photoxydation pour le composé organique incolore ou pratiquement incolore (a).

5. Matériaux d'enregistrement photopolymérisables selon la revendication 4, caractérisés par le fait qu'ils contiennent, comme initiateur de photopolymérisation et/ou photoxydant, au moins un héxaarylbisimidazolyle.

6. Matériaux d'enregistrement photopolymérisables selon la revendication 4, caractérisés par le fait qu'ils contiennent, comme photoxydant (b), au moins un sel de N-alcoxypyridinium.

7. Matériaux d'enregistrement photopolymérisables selon l'une des revendications 1 à 6, caractérisés par le fait qu'ils contiennent, comme composé organique incolore ou pratiquement incolore, qui est oxydable en un composé coloré, un colorant leuco, en particulier un colorant triarylméthane sous sa forme leuco.

8. Couches photoresist à base de matériaux d'enregistrement photopolymérisables selon l'une des revendications 1 à 7.

9. Plaque d'impression offset à bases de matériaux d'enregistrement photopolymérisables selon l'une des revendications 1 à 7.

10. Composés quinazolone-4 de la formule suivante

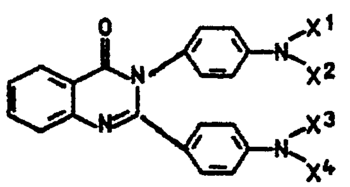

dans laquelle $X^1$, $X^2$, $X^3$ et $X^4$ sont identiques ou différents les uns des autres et sont mis pour des restes hydrocarbures à 1 à 12 atomes de carbone, qui peuvent être substitués par OH, CN, halogène, phényle, –O–CO-alkyle en $C_1$–$C_6$, –CO–O-alkyle en $C_1$–$C_6$ ou oxaalkyle à 3 à 12 atomes de carbones et 1 à 5 atomes d'oxygène.

11. Composés quinazolone-4 selon la revendication 10 caractérisés par le fait que $X^1$ à $X^4$ représentent des restes alkyle à 1 à 4 atomes de carbone.

12. Composés quinazolone-4 selon l'une des revendications 10 ou 11, caractérisés par le fait que les restes $X^1$ à $X^4$ représentent des groupes méthyle ou éthyle.